(19) Europäisches Patentamt
European Patent Office
Office européen des brevets

(11) **EP 1 528 400 B1**

(12) **EUROPEAN PATENT SPECIFICATION**

(45) Date of publication and mention
of the grant of the patent:
**15.08.2007 Bulletin 2007/33**

(51) Int Cl.:
***G01R 31/302*** *(2006.01)*     ***G01R 31/311*** *(2006.01)*

(21) Application number: **04025339.5**

(22) Date of filing: **25.10.2004**

(54) **Noncontact testing of integrated circuits**

Kontaktloses Prüfen integrierter Schaltungen

Test sans contact de circuits intégrés

(84) Designated Contracting States:
**DE FR GB**

(30) Priority: **29.10.2003 JP 2003369087**

(43) Date of publication of application:
**04.05.2005 Bulletin 2005/18**

(73) Proprietor: **NEC Electronics Corporation
Kawasaki, Kanagawa 211-8668 (JP)**

(72) Inventor: **Nikawa, Kiyoshi
Kawasaki
Kanagawa 211-8668 (JP)**

(74) Representative: **Baronetzky, Klaus et al
Splanemann Reitzner
Baronetzky Westendorp
Patentanwälte
Rumfordstrasse 7
80469 München (DE)**

(56) References cited:
**EP-A- 0 990 918     US-A1- 2003 016 026
US-B1- 6 505 312**

• **PATENT ABSTRACTS OF JAPAN vol. 1999, no. 01, 29 January 1999 (1999-01-29) & JP 10 274669 A (NEC CORP), 13 October 1998 (1998-10-13)**

**Description**

BACKGROUND OF THE INVENTION

Field of the Invention

The present invention relates to a nondestructive and noncontact analysis system for analyzing and evaluating an object, such as a semiconductor wafer, in which an electric current is induced when being irradiated with a light beam having a given wavelength, and more particularly relates to such a nondestructive and noncontact analysis system including a SQUID (Superconducting Quantum Interference Device) photoscanning microscopic method using a SQUID magnetic sensor, for the analysis of the object.

Description of the Related Art

Presently, nondestructive and noncontact analysis systems having a SQUID magnetic sensor have been researched and developed to be put into practical use for analyzing and evaluating semiconductor wafers.

Such a prior art nondestructive and noncontact analysis system includes a system control unit having a microcomputer, and a laser beam generation/modulation apparatus operated under control of the system control unit. The laser beam generation/modulation apparatus has a laser beam generator/modulator, and a reference signal generator.

For example, the laser beam generator/modulator contains a fiber laser device for generating and emitting a laser beam, and an acoustic optical device for modulating the emitted laser beam. The reference signal generator generates a reference signal composed of a series of regular pulses, and the reference signal is output as a modulation signal from the reference signal generator to the acoustic optical device of the laser beam generator/modulator, such that the laser beam is modulated in accordance with the modulation signal.

The laser beam generation/modulation apparatus also has an optical unit optically connected to laser beam generator/modulator through an optical fiber. Namely, the modulated laser beam is introduced from the laser beam generator/modulator into the optical unit through the optical fiber. The optical unit includes an optical lens system for focusing the modulated laser beam. Namely, the modulated laser beam is focused and emitted from the optical unit as a modulated and focused laser beam.

The nondestructive and noncontact analysis system further includes an X-Y stage, and an object, such as a silicon wafer, to be analyzed and evaluated, is detachably mounted on the X-Y stage. Note, the silicon wafer has a plurality of semiconductor chips or devices produced thereon.

The X-Y stage has a central opening formed therein, and the silicon wafer is irradiated with the modulated and focused laser beam, which passes through the central opening of the X-Y stage. The X-Y stage is moved along an X-axis and Y-axis of a rectangular X-Y coordinate defined with respect to the X-Y stage, such that each of the semiconductor devices on the silicon wafer is scanned with the laser beam. During the scanning of the semiconductor device with the laser beam, an electric current or OBIC (Optical Beam Induced Current) is induced at a spot area of the semiconductor device, which is irradiated with the scanning laser beam, and the OBIC generates a magnetic field (magnetic flux).

To detect the magnetic field, the nondestructive and noncontact analysis system is provided with a magnetism detection apparatus which includes a SQUID (Superconducting Quantum Interference Device) magnetic sensor, and a SQUID controlling/processing circuit containing an FLL (Flux Lock Loop) circuit. The SQUID magnetic sensor is controlled by the SQUID controlling/processing circuit, and detects the magnetic field to thereby produce a SQUID signal in accordance with an intensity of the detected magnetic field. Namely, while the semiconductor device is scanned with the modulated and focused laser beam, a series of SQUID signals are produced and output from the SQUID magnetic sensor to the SQUID controlling/processing circuit, in which the series of SQUID signals are suitably processed to thereby generate a magnetic field signal.

The nondestructive and noncontact analysis system is also provided with a signal extraction circuit containing a two-phase type lock-in amplifier. While the magnetic field signal is input from the SQUID controlling/processing circuit to the signal extraction circuit, the reference signal is input from the reference signal generator to the signal extraction circuit.

In the two-phase type lock-in amplifier of the signal extraction circuit, the same frequency components as those of the reference signal are extracted from the magnetic field signal, and are suitably processed and output from the signal extraction circuit as a magnetic field intensity signal.

The magnetic field intensity signal is fed to the system control unit, and then is successively converted into digital magnetic field intensity image data by an analog-to-digital (A/D) convector included in the system control unit. When the scanning of the semiconductor device concerned is completed, a frame of digital magnetic field intensity image pixel data is produced based on the successively-converted digital magnetic field intensity data, and is stored in a random access memory (RAM) included in the system control unit.

The nondestructive and noncontact analysis system is further provided with a personal computer associated with a TV monitor. The frame of magnetic field intensity image pixel data is fed from the system control unit to the personal computer, and is suitably processed to thereby produce a magnetic field intensity video signal, whereby a magnetic field intensity image is displayed on the TV monitor in accordance with the magnetic field intensity video signal.

In general, the magnetic field intensity image, which is obtained by using the SQUID photoscanning microscopic method, is called a SQUID microscopic image, and a spatial resolution power of the SQUID microscopic image depends upon only a spot diameter of the scanning laser beam projected on the object to be analyzed and evaluated, with no relationship to a size of the SQUID magnetic sensor and the distance between the SQUID magnetic sensor and the object. Note, usually, the spatial resolution power of the SQUID microscopic image is on the order of submicrons.

The SQUID photoscanning microscopic method is used to detect a distribution of impurity density on a bare silicon wafer, as disclosed in literature "SQUID Photoscanning: An Imaging Technique for UDN of Semiconductor Wafers and Devices based on Photomagnetic Detection" , reported in "IEEE Transactions on Applied Superconductivity" , U.S.A., March, 2001, Vol. 1, P. 1162-1167, by Jorn Beyer, Dietmar Drung and Thomas Schuring.

Also, the SQUID photoscanning microscopic method is used to measure a diffusion length of small carriers in a diffusion layer formed in a silicon wafer, as disclosed in JP-A-2003-197700.

Further, the SQUID photoscanning microscopic method is used to analyze and evaluate semiconductor chips or devices, produced in a silicon wafer, using SQUID microscopic images, or magnetic field intensity images derived therefrom, as disclosed in JP-A-2002-313859.

In the above-mentioned prior art nondestructive and noncontact analysis system using the SQUID photoscanning microscopic method, a magnetic field intensity image derived from a semiconductor device is frequently compared with a magnetic field intensity image derived from another semiconductor device, with the two semiconductor devices being identical to each other. In this case, if the two semiconductor devices are good products, the magnetic field intensity images cannot be distinguished from each other. On the other hand, if one of the semiconductor devices has a defect, the magnetic field intensity image derived from the defective semiconductor device is different from the magnetic field intensity image derived from the good semiconductor device at a local area at which the defect exists in the defective semiconductor device.

Nevertheless, in the prior art nondestructive and noncontact analysis system, it is difficult to distinguish the difference between the defective and good magnetic field intensity images, as stated in detail hereinafter.

SUMMARY OF THE INVENTION

Therefore, an object of the present invention is to provide a nondestructive and noncontact analysis system using a SQUID photoscanning microscopic method, which is constituted such that an analysis and an evaluation of an object, such as a semiconductor wafer, can be more accurately carried out in comparison with the prior art nondestructive and noncontact analysis system.

Another object of the present invention is to provide a nondestructive and noncontact analysis method performed in the aforesaid nondestructive and noncontact analysis system.

In accordance with an aspect of the present invention, there is provided a nondestructive and noncontact analysis system for analyzing and evaluating an object. In this nondestructive and noncontact analysis system, a light beam generation/modulation apparatus emits a modulated and focused light beam to thereby irradiate the object, and the modulation of the modulated and focused light beam is carried out with a modulation signal synchronized with a reference signal composed of a series of regular pulses. A a magnetism detection apparatus detects a magnetic field, which is generated by an electric current induced by irradiating the object with the modulated and focused light beam, to thereby produce a magnetic field signal. A signal extraction circuit extracts a phase difference signal between the reference signal and the magnetic field signal. An image data production system produces phase difference image data based on the phase difference signal.

Preferably, the nondestructive and noncontact analysis system further comprises a scanning system that scans the object with the modulated and focused light beam, to thereby induce a series of electric currents at spot areas of the object, which are irradiated with the modulated and focused light beam.

The image data production system may include a gradation conversion system for converting gradations of the phase difference image data in accordance with a predetermined gradation characteristic.

The nondestructive and noncontact analysis system may comprises an image display system for displaying a phase difference image based on the phase difference image data.

The nondestructive and noncontact analysis system may comprise an image display system for displaying a phase difference image based on the phase difference image data together with a referential phase difference image based on previously-prepared referential phase difference image data, whereby the phase difference image can be compared with the referential phase difference image.

The nondestructive and noncontact analysis system may comprise an image display system for displaying a phase difference histogram based on phase difference histogram data which is produced from the phase difference image data.

The nondestructive and noncontact analysis system may further comprise an image display system for displaying a phase difference histogram based on the phase difference histogram data together with a referential phase difference histogram based on previously-prepared referential phase difference histogram data, whereby the phase difference histogram can be compared with the referential phase difference histogram.

According to the present invention, the signal extraction circuit may extract a magnetic field intensity signal from the magnetic field signal, and the image data production system may produce a magnetic field intensity image data based on the magnetic field intensity signal.

The nondestructive and noncontact analysis system may comprise an image display system for displaying a magnetic field intensity image and a phase difference image based on the magnetic field intensity image data and the phase difference image data, respectively.

The nondestructive and noncontact analysis system may further comprise an image display system for displaying respective magnetic field intensity and phase difference images based on the magnetic field intensity image and phase difference image data together with respective referential magnetic field intensity and phase differential images based on previously-prepared referential magnetic field intensity image and phase difference image data, whereby the respective magnetic field intensity and phase difference images can be compared with the referential magnetic field intensity and phase difference images.

The nondestructive and noncontact analysis system may further comprise an image display system for displaying respective magnetic field intensity and phase difference histograms based on magnetic field intensity histogram and phase difference histograms which are produced from the magnetic field intensity image and phase difference image data, respectively.

The nondestructive and noncontact analysis system may further comprise an image display system for displaying respective magnetic field intensity and difference histograms based on magnetic field intensity histogram and phase difference histogram data, which are produced from the magnetic field intensity image and phase difference image data, respectively, together with respective referential magnetic field intensity and phase difference histograms based on previously-prepared referential magnetic field intensity histogram and phase difference histogram data, whereby the magnetic field intensity histogram and the phase difference histogram can be compared with the referential magnetic field intensity histogram and the referential phase difference histogram, respectively.

Preferably, the modulated and focused light beam is emitted as a modulated and focused laser beam from the light beam generation/modulation apparatus, and the magnetism detection apparatus includes a SQUID (Superconducting Quantum Interference Device) magnetic sensor to detect the magnetic fields generated in the object by each of the electric currents.

In accordance with another aspect of the present invention, there is provided a nondestructive and noncontact analysis method for analyzing and evaluating an object, comprising the steps of: emitting an modulated and focused light beam to thereby irradiate the object, the modulation of the modulated and focused light beam being carried out with a modulation signal synchronized with a reference signal composed of a series of regular pulses; detecting a magnetic field, which is generated by an electric current induced by irradiating the object with the modulated and focused light beam, to thereby produce a magnetic field signal; extracting a phase difference signal between the reference signal and the magnetic field signal; and producing phase difference image data based on the phase difference signal.

Preferably, the nondestructive and noncontact analysis method further comprises the step of scanning the object with the modulated and focused light beam, to thereby induce a series of electric currents at spot areas of the object, which are irradiated with the modulated and focused light beam.

The phase difference image data may be subjected to a gradation conversion processing such that gradations of the phase difference image data are converted in accordance with a predetermined gradation characteristic.

The nondestructive and noncontact analysis method may comprise the step of displaying a phase difference image in an image display system based on the phase difference image data.

The nondestructive and noncontact analysis method may comprise the step of displaying a phase difference image in an image display system based on the phase difference image data together with a referential phase difference image based on previously-prepared referential phase difference image data, whereby the phase difference image can be compared with the referential phase difference image.

The nondestructive and noncontact analysis method may comprise the steps of: producing phase difference histogram data from the phase difference image data; and displaying a phase difference histogram in an image display system based on the phase difference histogram data.

The nondestructive and noncontact analysis method may comprise the steps of: producing phase difference histogram data from the phase difference image data; and displaying a phase difference histogram in an image display system based on the phase difference histogram data together with a referential phase difference histogram based on previously-prepared referential phase difference histogram data, whereby the phase difference histogram can be compared with the referential phase difference histogram.

The nondestructive and noncontact analysis method may comprise the steps of: extracting a magnetic field intensity signal from the magnetic field signal; and producing magnetic field intensity image data based on the magnetic field intensity signal.

The nondestructive and noncontact analysis method may comprise the step of displaying a magnetic field intensity image and a phase difference image in an image display system based on the magnetic field intensity image data and the phase difference image data.

The nondestructive and noncontact analysis method may comprise the step of displaying respective magnetic field intensity and phase difference images based on the magnetic field intensity image and phase difference image data together with respective referential magnetic field intensity and phase difference images based on previously-prepared referential magnetic field intensity image and phase difference image data, whereby the magnetic field intensity image and the phase difference image can be compared with the referential magnetic field intensity image and the referential phase difference image, respectively.

The nondestructive and noncontact analysis method may comprise the step of producing magnetic field intensity histogram data and phase difference histogram data from the magnetic field intensity image data and the phase difference image data, respectively.

The nondestructive and noncontact analysis method may comprise the step of displaying respective magnetic field intensity and phase difference histograms based on the magnetic field intensity histogram and phase difference histogram data together with referential magnetic field intensity and phase difference histograms based on previously-prepared magnetic field intensity histogram phase difference histogram data, whereby the magnetic field intensity histogram and the phase difference histogram can be compared with the referential magnetic field intensity histogram and the referential phase difference histogram, respectively.

BRIEF DESCRIPTION OF THE DRAWINGS

The above object and other objects will be more clearly understood from the description set forth below, with reference to the accompanying drawings, wherein:

Figure 1 is a block diagram of an embodiment of a nondestructive and noncontact analysis system according to the present invention, in which a silicon wafer is analyzed and evaluated;

Figure 2 is a block diagram of a system control unit included in the nondestructive and noncontact analysis system shown in Fig. 1;

Figure 3 is a view conceptually showing relationships between a reference signal, a modulation signal and a magnetic field intensity signal, which are produced in the nondestructive and noncontact analysis system shown in Fig. 1;

Figure 4 is a view conceptually showing a scanning manner in which a semiconductor chip on the silicon wafer is scanned with a modulated and focused laser beam which is generated in the nondestructive and noncontact analysis system shown in Fig. 1;

Figure 5 is a view conceptually showing a frame of mxn magnetic field intensity image pixel data, which is stored in a random access memory (RAM) included in the system control unit;

Figure 6 is a view conceptually showing a frame of mxn phase difference image pixel data, which is stored in the random access memory (RAM) included in the system control unit;

Figure 7 is a view conceptually showing a one-dimensional map, which is stored in a read-only memory (ROM) included in the system control unit, and which is used to subject the phase difference image pixel data to a gradation conversion processing;

Figure 8 is a block diagram of a personal computer included in the nondestructive and noncontact analysis system shown in Fig. 1;

Figure 9A is a real magnetic field intensity image which is produced based on a frame of magnetic field intensity image pixel data derived from a defective semiconductor device;

Figure 9B is a real magnetic field intensity image which is produced based on a frame of magnetic field intensity image pixel data derived from a good semiconductor device;

Figure 10A is a real phase difference image which is produced based on a frame of phasedifference image pixel data derived from the aforesaid defective semiconductor device;

Figure 10B is a real phase difference image which is produced based on a frame of phase difference image pixel data derived from the aforesaid good semiconductor device;

Figure 11A is a real magnetic field intensity histogram which is produced from the frame of magnetic field intensity image pixel data derived from the aforesaid defective semiconductor device;

Figure 11B is a real magnetic field intensity histogram which is produced from the frame of magnetic field intensity image pixel data derived from the good semiconductor device;

Figure 12A is a real phase difference histogram which is produced from the frame of phase difference image pixel data derived from the defective semiconductor device;

Figure 12B is a real phase difference histogram which is produced from the frame of phase difference image pixel data derived from the good semiconductor device;

Figure 13 is a flowchart of a main routine executed in the system control circuit of the nondestructive and noncontact analysis system;

Figure 14 is a flowchart of an image production routine executed as a subroutine in the main routine of Fig. 13;

Figure 15 is a flowchart of a main routine executed in the personal computer of the nondestructive and noncontact analysis system; and

Figure 16 is a flowchart of a histogram production routine executed as a subroutine in the main routine of Fig. 15.

DESCRIPTION OF THE PREFERRED EMBODIMENTS

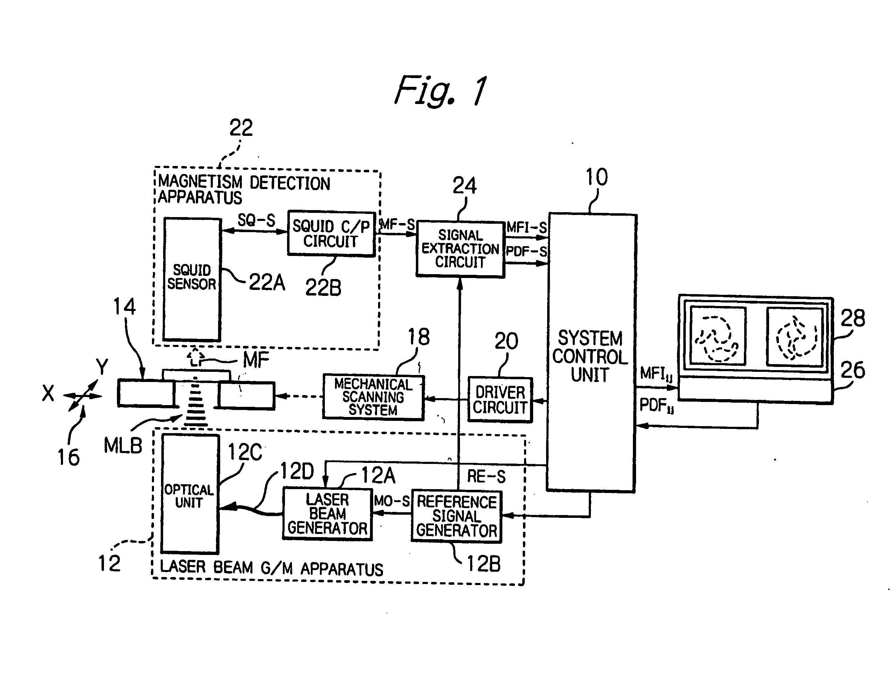

With reference to Figs. 1 to 3, an embodiment of a nondestructive and noncontact analysis system according to the present invention will be now explained below.

The nondestructive and noncontact analysis system is used to analyze and evaluate an object, such as a silicon wafer, to be analyzed and evaluated, in which an electric current is induced when being irradiated with a laser beam. Note, as already stated hereinbefore, such an electric current is called an OBIC (Optical Beam Induced Current) in this field.

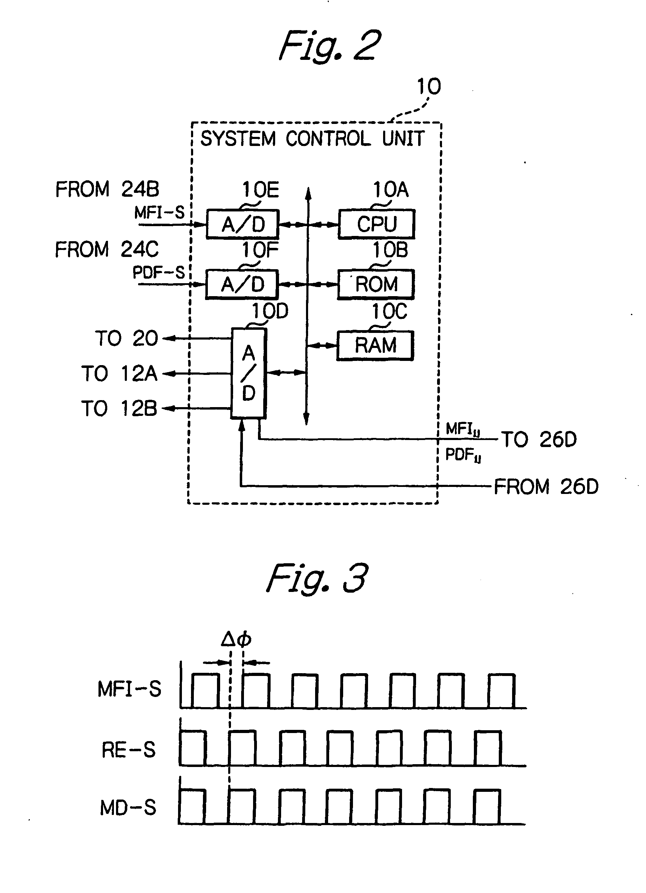

The nondestructive and noncontact analysis system comprises a system control unit 10, which is constituted as a microcomputer as shown in Fig. 2. Namely, the system control unit 10 includes a central processing unit (CPU) 10A, a read-only memory (ROM) 10B for storing various programs and constants, a random-access memory (RAM) 10C for storing temporary data, an input/output (I/0) interface circuit 10D, and two analog-to-digital (A/D) converters 10E and 10F.

Also, the nondestructive and noncontact analysis system comprises a laser beam generation/modulation apparatus 12 including a laser beam generator/modulator 12A, and a reference signal generator 12B. In this embodiment, for example, the laser beam generator/modulator 12A contains a fiber laser device for generating and emitting a laser beam, and an acoustic optical device for modulating the emitted laser beam. The reference signal generator 12B generates a reference signal RE-S composed of a series of regular pulses, and outputs a modulation signal MO-S to the acoustic optical device of the laser beam generator/modulator 12 in synchronization with the reference signal RE-S, to thereby modulate the laser beam in accordance with the modulation signal MD-S.

Note, the laser beam generator/modulator 12A and the reference signal generator 12B are connected to the I/0 interface circuit 10D, and are driven under control of the system control unit 10.

The laser beam generation/modulation apparatus 12 further includes an optical unit 12C optically connected to laser beam generator/modulator 12A through an optical fiber 12D, which is symbolically and conceptually illustrated in Fig. 1. Namely, the modulated laser beam is introduced from the laser beam generator/modulator 12A into the optical unit 12C through the optical fiber 12D. The optical unit 12C includes an optical lens system for focusing the modulated laser beam. Namely, the modulated laser beam is focused and emitted from the optical unit 12D as a modulated and focused laser beam MLB, which is symbolically and conceptually illustrated in Fig. 1.

The nondestructive and noncontact analysis system further comprises an X-Y stage 14, and an object, such as a silicon wafer, to be analyzed and evaluated, is detachably mounted on the X-Y stage 14. In Fig. 1, the silicon wafer to be analyzed and evaluated is indicated by reference SW. The X-Y stage has a central opening formed therein, and the silicon wafer SW is irradiated with the modulated and focused laser beam MLB, which passes through the central opening of the X-Y stage 14.

The X-Y stage 14 is movable along an X-axis and Y-axis of a rectangular X-Y coordinate 16 defined with respect to the X-Y stage 14, such that the silicon wafer SW is scanned with the laser beam MLB. To this end, the X-Y stage is mechanically associated with a mechanical scanning system 18, and the mechanical association between the X-Y stage 14 and the mechanical scanning system 18 is conceptually represented by a broken arrow BA in Fig. 1. The mechanical scanning system contains two respective electric drive motors for moving the X-Y stage 14 along the X-axis and Y-axis of the rectangular X-Y coordinate 16, and these electric drive motors are driven by a driver circuit 20, which is operated under control of the system control unit 10.

While the silicon wafer SW is scanned with the modulated and focused laser beam MLB, a series of electric currents (OBIC) are induced at spot areas of the silicon wafer SW, which are irradiated with the scanning laser beam MLB, and each of the electric currents generates a magnetic field (magnetic flux) MF, which is conceptually represented by an open arrow illustrated by a broken line in Fig. 1.

In order to detect the magnetic field MF, the nondestructive and noncontact analysis system is provided with a magnetism detection apparatus 22 which includes a SQUID (Superconducting Quantum Interference Device) magnetic sensor 22A of HTS (High Temperature Superconducting) type, and a SQUID controlling/processing circuit 22B containing an FLL (Flux Lock Loop) circuit. Note, the HTS type SQUID magnetic sensor can detect a very small magnetic field density of less than 1 pT (pico-tesla).

The SQUID magnetic sensor 22A is controlled by the SQUID controlling/processing circuit 22B, and detects the magnetic field MF to thereby produce a SQUID signal SQ-S in accordance with an intensity of the detected magnetic field MF. Namely, while the silicon wafer SW is scanned with the modulated and focused laser beam MLB, a series of SQUID signals SQ-S are produced and output from the SQUID magnetic sensor 22A to the SQUID controlling/processing circuit 22B, in which the series of SQUID signals SQ-S are suitably processed to thereby produce a magnetic field signal MF-S.

Although not illustrated in Fig. 1, in reality, the magnetism detection apparatus 22 is covered with a magnetic shield to thereby protect it from an environmental magnetic field. Namely, since a density of the environmental magnetic field is on the order of $\mu T$ (micro-tesla), it should be reduced to the order of nT (nano-tesla) before the magnetism detection apparatus 22 can be stably operated.

The nondestructive and noncontact analysis system is also provided with a signal extraction circuit 24 which may contain a two-phase type lock-in amplifier. As is apparent from Fig. 1, while the magnetic field signal MF-S is input from the SQUID controlling/processing circuit 22B to the signal extraction circuit 24, the reference signal RE-S is input from the reference signal generator 12B to the signal extraction circuit 24.

In the two-phase type lock-in amplifier of the signal extraction circuit 24, the same frequency components as those of the reference signal RE-S are extracted from the magnetic field signal MF-S, and are suitably processed and output from the signal extraction circuit 24 as a magnetic field intensity signal MFI-S. On the other hand, in the two-phase type lock-in amplifier, respective phase differences between the extracted frequency components of the magnetic field signal MF-S and the corresponding pulses of the reference signal RE-S are detected and output from the signal extraction circuit 24 as a phase difference signal PDF-S.

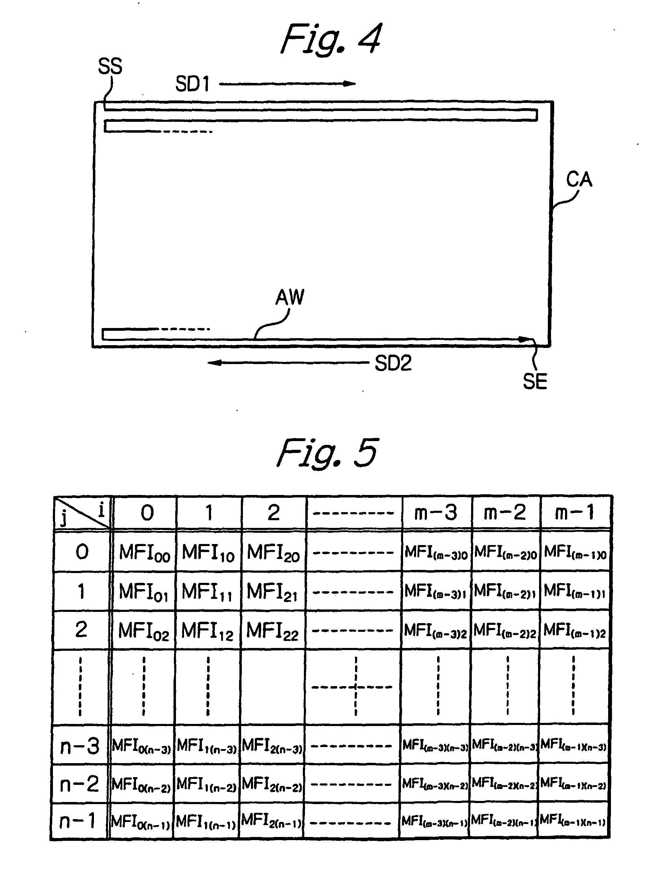

Figure 3 conceptually shows relationships between the reference signal RE-S, the modulation signal MO-S, and the magnetic field intensity signal MFI-S.

As shown in Fig. 3, the magnetic field intensity signal MFI-S is composed of the frequency components which are extracted from the magnetic field signal MF-S in accordance with the reference signal RE-S, and each of the frequency components features a phase difference with respect to a corresponding pulse of the reference signal RE-S. In Fig. 3, a phase difference between a frequency component of the magnetic field intensity signal MFI-S and a corresponding pulse of the reference signal RE-S is representatively indicated by reference $\Delta\phi$. In short, the phase difference signal PDF-S is composed of the consecutive phase differences ($\Delta\phi$) between the extracted frequency components of the magnetic field signal MF-S and the corresponding pulses of the reference signal RE-S.

Note, in Fig. 3, although the frequency components of the magnetic field intensity signal MFI-S are expediently illustrated as a series of regular rectangular pulses, in reality, the frequency components cannot be represented by regular rectangular pulses. Namely, both the amplitude and the phase difference ($\Delta\phi$) of the frequency components of the magnetic field intensity signal MFI-S might vary in accordance with the spot areas of the silicon wafer SW, which are irradiated with the scanning laser beam MLB.

As is apparent from Figs. 1 and 2, the magnetic field intensity signal MFI-S and the phase difference signal PDF-S are input from the signal extraction circuit 24 to the respective A/D converters 10E and 10F of the system control unit 10.

In this embodiment, the silicon wafer SW has a plurality of semiconductor chip areas defined thereon, and a semiconductor device is produced in each of the chip areas. In order to analyze each of the semiconductor devices, it is scanned with the modulated and focused laser beam MLB, for example, in a scanning manner as conceptually shown in Fig. 4. In particular, in Fig. 4, one of the chip areas on the silicon wafer SW is representatively indicated by reference CA, and the chip area CA is scanned with the laser beam MLB along a zigzag arrow AW. Note, reference SS indicates a scanning start position, and reference SE indicates a scanning end position. Also, note, reference SD1 indicates a first scanning direction in which the chip area CA is scanned with the laser beam MLB when moving it in the right direction (Fig. 4), and reference SD2 a second scanning direction in which the chip area CA is scanned with the laser beam MLB when moving it in the left direction (Fig. 4).

While the chip area CA is scanned with the laser beam MLB in the scanning manner as shown in Fig. 4, the magnetic field intensity signal MFI-S and the phase difference signal PDF-S are successively converted into 8-bit digital magnetic field intensity data MFI and 8-bit digital phase difference data PDF by the respective A/D convertors 10E and 10F.

When the scanning of the chip area CA is completed, a frame of 8-bit digital magnetic field intensity image pixel data $MFI_{ij}$ is produced based on the successively-converted 8-bit digital magnetic field intensity data MFI, and is stored in the RAM 10C of the system control unit 10, as conceptually shown in Fig. 5. As is apparent from this drawing, in this embodiment, the magnetic field intensity image on the chip area CA is composed of a frame of mxn image pixel data $MFI_{ij}$, and each of these image pixel data $MFI_{ij}$ is defined as an average value of the consecutive ten digital magnetic field intensity data MFI.

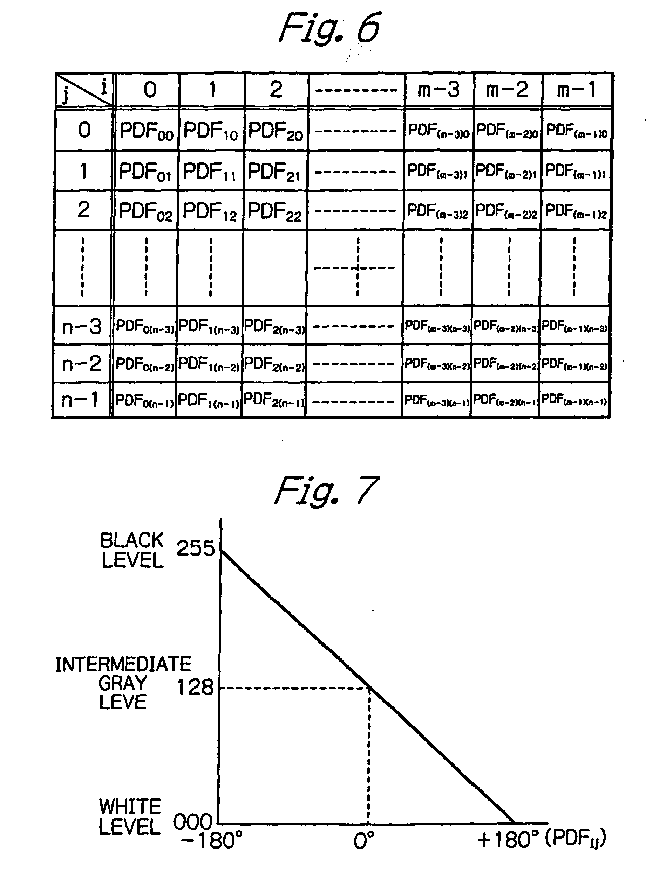

Similarly, when the scanning of the chip area CA is completed, a frame of 8-bit digital phase difference image pixel data $PDF_{ij}$ is produced based on the successively-converted 8-bit digital phase difference data PDF, and is stored in the RAM 10C of the system control unit 10, as conceptually shown in Fig. 6. As is apparent from this drawing, the phase difference image on the chip area CA is also composed of a frame of mxn image pixel data $PDF_{ij}$, and each of these image pixel data $PDF_{ij}$ is defined as an average value of the consecutive ten digital phase difference data PDF.

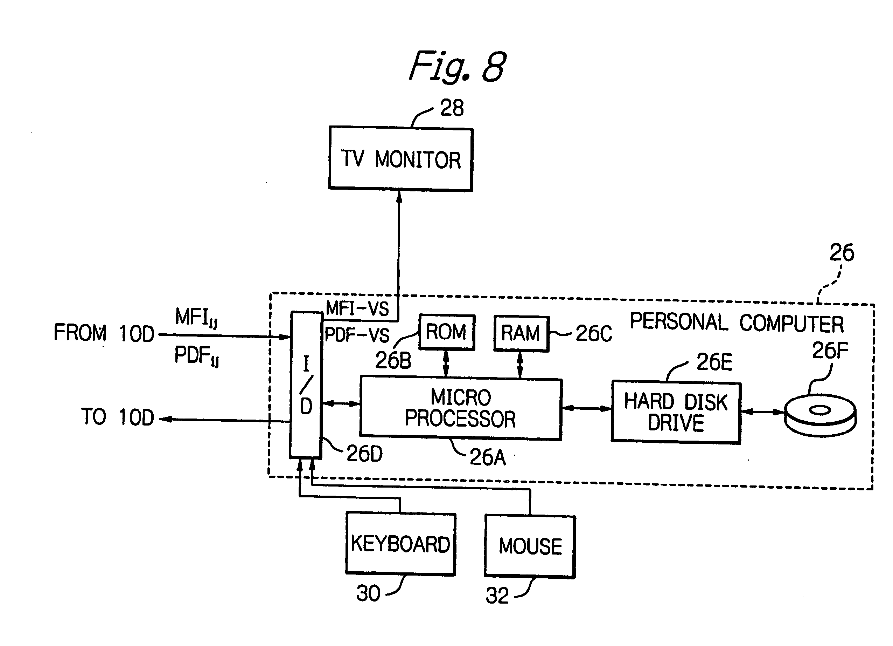

In this embodiment, before each of the image pixel data $PDF_{ij}$ is stored in the RAM 10C of the system control unit 10, it is subjected to a gradation conversion processing, using a one-dimensional map, as conceptually shown in Fig. 7 by way of example, which is previously defined and stored in the ROM 10B of the system control unit 10. As is apparent from Fig. 7, for example, when an image pixel datum $PDF_{ij}$ represents a phase difference $\Delta\phi$ of -180°, it is converted into an image pixel datum $PDF_{ij}$ featuring a black level "255". Also, when an image pixel datum $PDF_{ij}$ represents a phase difference $\Delta\phi$ of 0°, it is converted into an image pixel datum $PDF_{ij}$ featuring an intermediate gray level "128". Further, when an image pixel datum $PDF_{ij}$ represents a phase difference $\Delta\phi$ of +180°, it is converted into an image pixel datum $PDF_{ij}$ featuring a white level "000".

On the contrary, if necessary, the image pixel datum PDF$_{ij'}$ representing the phase difference $\Delta\phi$ of -180°, may be converted as featuring the white level "000" , and the image pixel datum PDF$_{ij}$ representing a phase difference $\Delta\phi$ of +180°, is converted as featuring the black level "255" .

As shown in Fig. 1, the nondestructive and noncontact analysis system is further provided with a personal computer 26 associated with a TV monitor 28. As shown in Fig. 8, the personal computer 26 comprises a microprocessor 26A, a read-only memory (ROM) 26B for storing various programs and constants, a random-access memory (RAM) 26C for storing temporary data, and an input/output ( 1/0) interface circuit 26D. The TV monitor 28 is connected to the microprocessor 26A through the I/0 interface circuit 26D.

The personal computer 26 contains a hard disk drive 26E for driving a hard disk 26F. The microprocessor 26A writes various data on the hard disk 26F through the hard disk drive 26E, and also reads the various data from the hard disk 26F through the hard disk drive 26E. Further, the personal computer 26 is provided with a keyboard 30 and a mouse 32 which are connected to the microprocessor 26A through the I/0 interface circuit 26D. The keyboard 30 is used to input various commands and data to the microprocessor 26A, and a mouse 32 is used to input a command to the microprocessor 26A by clicking the mouse 32 on any one of the various command items displayed on the TV monitor 28.

The frames of mxn image pixel data MFI$_{ij}$ and PDF$_{ij}$ are fed from the system control unit 10 to the personal computer 26, and are temporarily stored in the RAM 26C of the personal computer 26. The microprocessor 26A suitably processes the frames of mxn image pixel data MFI$_{ij}$ and PDF$_{ij}$ to thereby produce video signals MFI-VS and PDF-VS, a magnetic field intensity image and a phase difference image are displayed on the TV monitor 28 in accordance with the respective video signals MFI-VS and PDF-VS. Note, the frames of mxn image pixel data MFI$_{ij}$ and PDF$_{ij}$ may be stored and reserved in the hard disk 26F, if necessary.

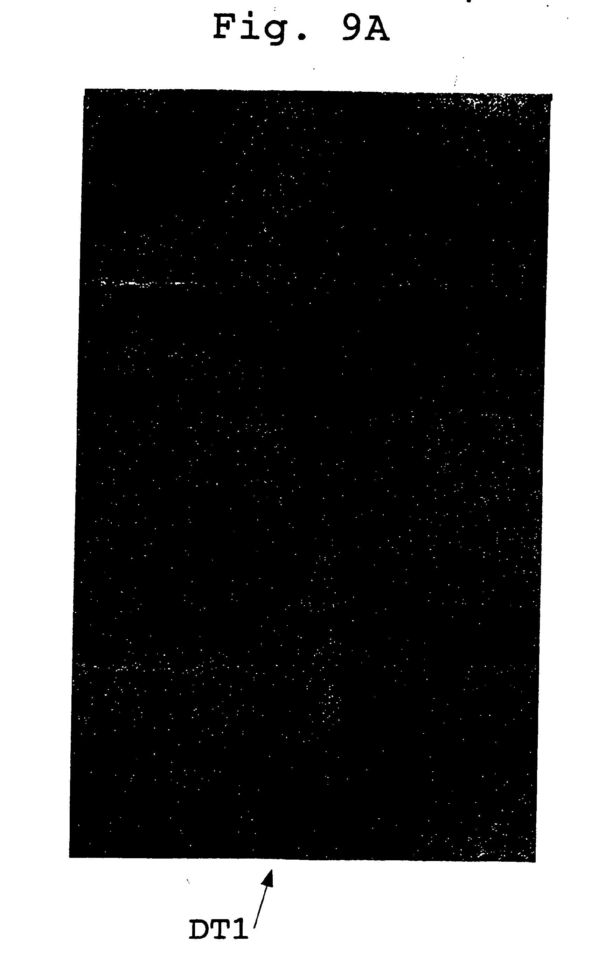

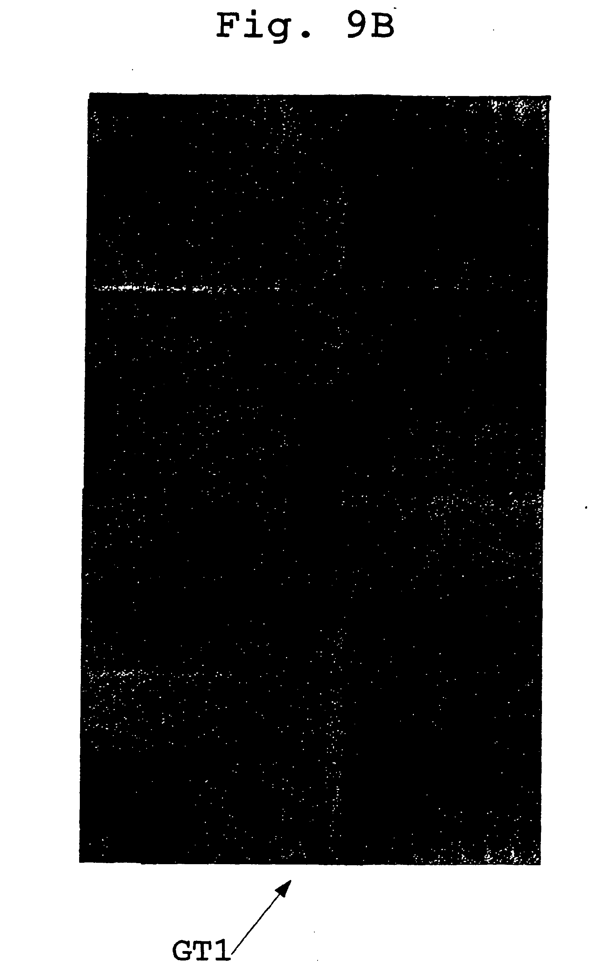

Figures 9A and 9B show two real magnetic field intensity images by way of example, which are displayed on the TV monitor 28. The magnetic field intensity image shown in Fig. 9A is derived from a defective semiconductor device produced in a silicon wafer (SF), and the magnetic field intensity image shown in Fig. 9B is derived from a good semiconductor device produced in the same silicon wafer (SF) as mentioned above. Note that the defective and good semiconductor devices are identical to each other, and have a size of 6 mm x 10 mm. As is apparent from a comparison between Figs. 9A and 9B, the respective magnetic field intensity images shown in Figs. 9A and 9B are distinguished from each other at local areas indicated by arrows DT1 and GD1. Namely, it is found that the defective semiconductor device (Fig. 9A) has a defect at the local area indicated by the arrow DT1.

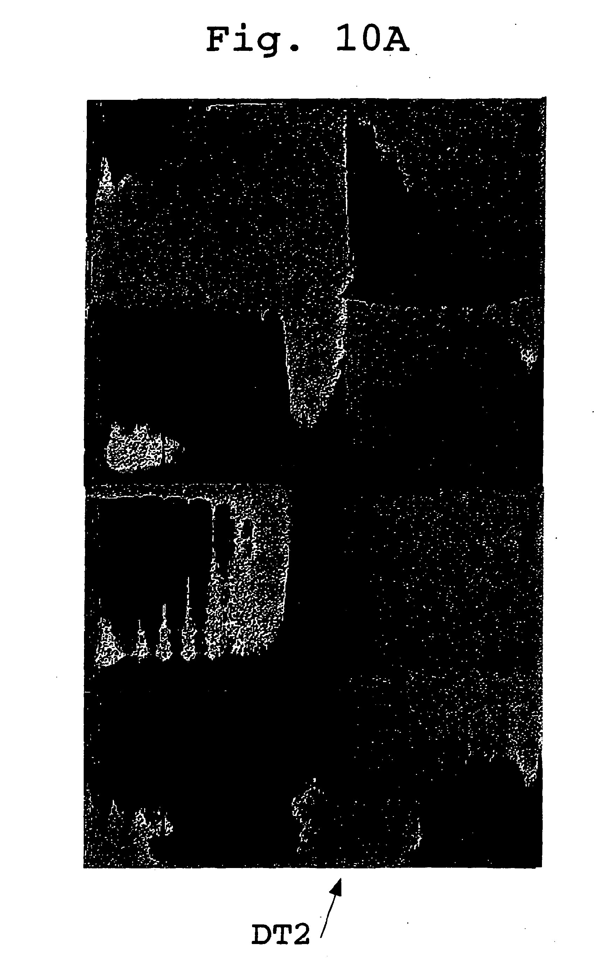

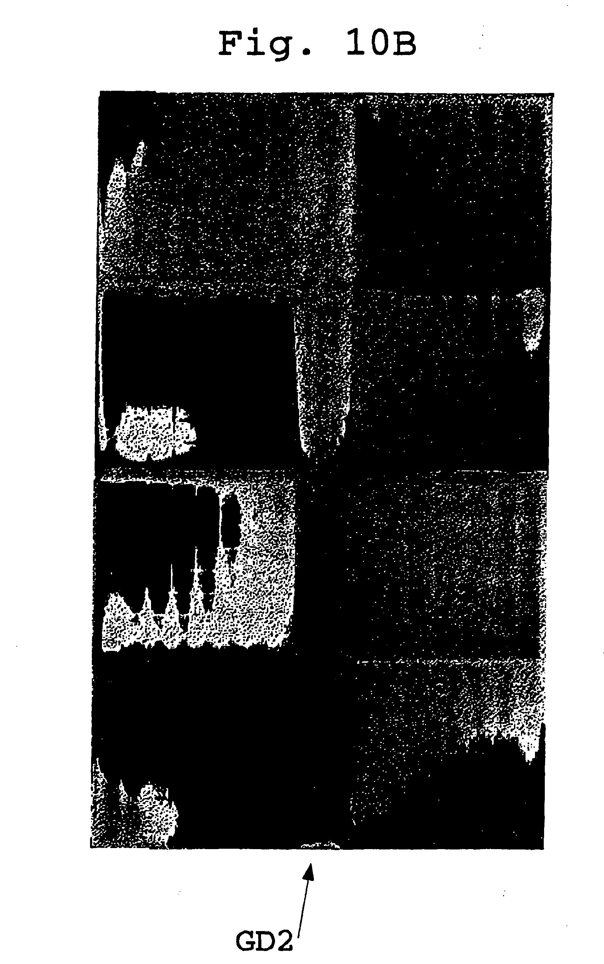

Figures 10A and 10B show two real phase difference images by way of example, which are displayed on the TV monitor 28. The phase difference image shown in Fig. 10A is derived from the aforesaid defective semiconductor device, and the phase difference image shown in Fig. 10B is derived from the aforesaid good semiconductor device. As is apparent from a comparison between Figs. 10A and 10B, the phase difference images shown in Figs. 10A and 10B are also distinguished from each other, at local areas indicated by arrows DT2 and GD2. Namely, the defective semiconductor device (Fig. 10A) has the defect at the local area indicated by the arrow DT2. Of course, the local area indicated by the arrow DT2 is the same area as indicated by the arrow DT1 in Fig. 9A.

Note, the four real images shown in Figs. 9A and 9B and Figs. 10A and 10B were obtained under the conditions that a spot diameter of the modulated and focused laser beam MLB is 10 $\mu$m, and that a frequency of the modulation signal MO-S is 100 kHz.

Comparing the magnetic field intensity images shown in Figs. 9A and 9B with the phase difference images shown in Figs. 10A and 10B, the existence of the defect in the defective semiconductor device can be more clearly recognized in the phase difference images than in the magnetic field intensity images. Namely, by using the phase difference images as shown in Figs. 10A and 10B, it is possible to more accurately analyze and evaluate the semiconductor devices produced in the silicon wafer SW, in comparison with the case where only the magnetic field intensity images are utilized.

In short, from the inventor's research, it was found that the respective phase differences between the frequency components of the magnetic field signal MF-S and the corresponding pulses of the reference signal RE-S are influenced by the existence of the defect in the semiconductor device, and more clearly represent the existence of the defect in the semiconductor device in comparison with the magnetic field intensity signal MF-S.

In this embodiment, if necessary, a magnetic field intensity histogram and a phase difference histogram may be produced based on the respective frames of mxn image pixel data MFI$_{ij}$ and PDF$_{ij}$, and may be displayed on the TV monitor 28. The production of the magnetic field intensity and phase difference histograms may be carried out in the personal computer 26.

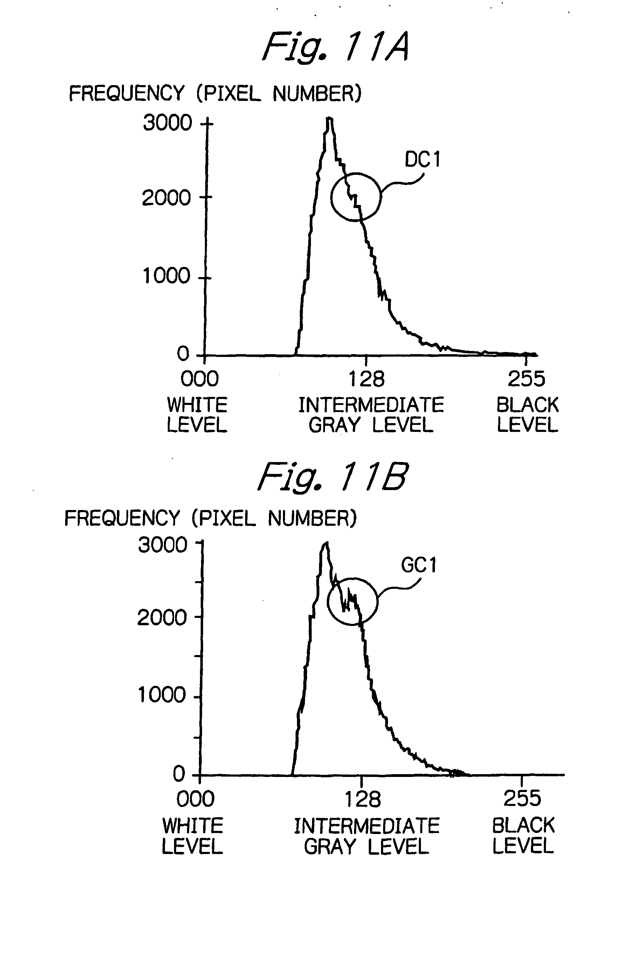

Figures 11A and 11B show two magnetic field intensity histograms produced based on the magnetic field intensity images shown in Figs. 9A and 9B. In these histograms, when 8-bit image pixel data MFI$_{ij}$ is equivalent to "000" , it represents a white level; when 8-bit image pixel data MFI$_{ij}$ is equivalent to "128" , it represents an intermediate gray level; and when 8-bit image pixel data MFI$_{ij}$ is equivalent to "255" , it represents a black level. As is apparent from a comparison between Figs. 11A and 11B, the respective magnetic field intensity histograms are distinguished from each other at sections encircled by circles DC1 and GC1.

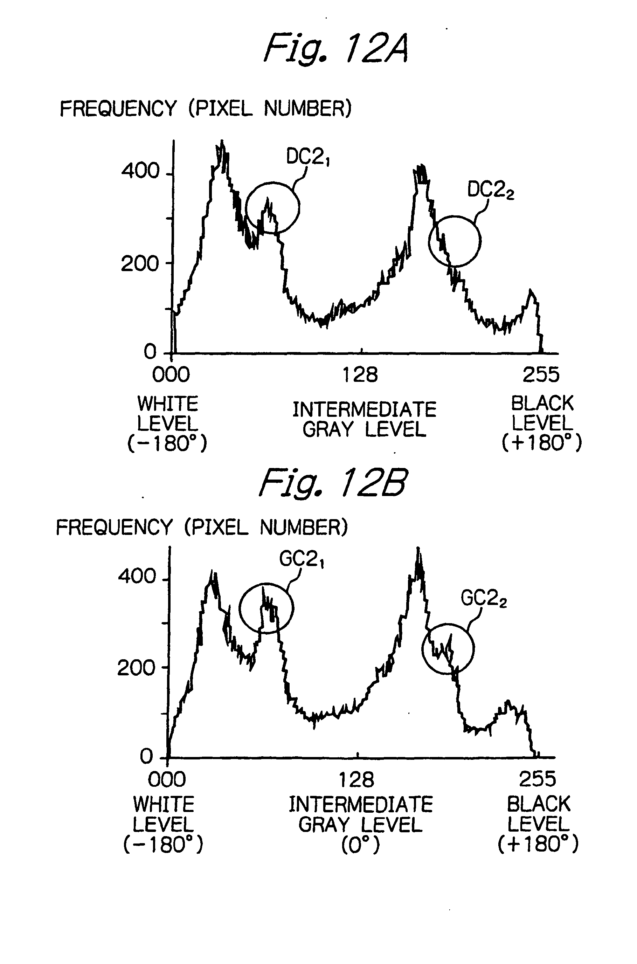

Figures 12A and 12B show two phase difference histograms produced based on the phase difference images shown in Figs. 10A and 10B. In these histograms, when 8-bit image pixel data $PDF_{ij}$ is equivalent to "000" ($\Delta\phi=-180°$), it represents a white level; when 8-bit image pixel data $PDF_{ij}$ is equivalent to "128" ($\Delta\phi=0°$), it represents an intermediate gray level; and when 8-bit image pixel data $PDF_{ij}$ is equivalent to "255" ($\Delta\phi=+180°$), it represents a black level. As is apparent from a comparison between Figs. 12A and 12B, the respective phase difference histograms are distinguished from each other at sections encircled by circles $DC2_1$ and $DC2_2$; and $GC2_1$ and $GC2_2$.

By using the histograms as shown in Figs. 11A and 11B and Figs. 12A and 12B, it is possible to more accurately analyze and evaluate the semiconductor devices produced in the silicon wafer SW, in comparison with the case where only the magnetic field intensity and phase difference images as shown in Figs. 9A and 9B and Figs. 10A and 10B are utilized.

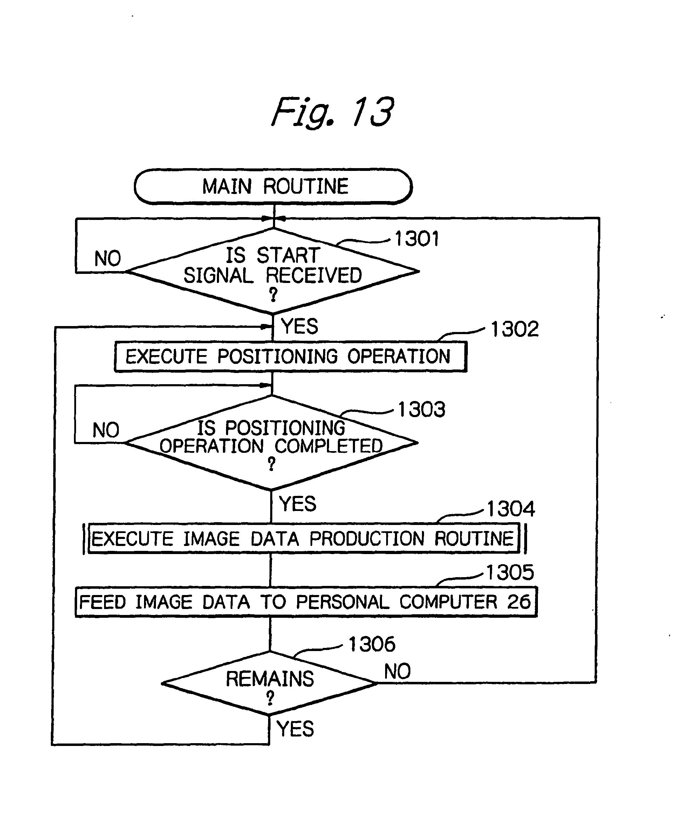

Figure 13 shows a flowchart of a main routine executed in the CPU 10A of the system control circuit 10. Note, the execution of the main routine is started when the nondestructive and noncontact analysis system is powered ON.

At step 1301, it is monitored whether a scanning-operation start signal is received from the personal computer 26. Note, after a silicon wafer (SW) to be analyzed and evaluated is mounted on the X-Y stage 14, when a command for feeding the scanning operation start signal to the system control unit 10 is input to the personal computer 26 by manipulating either the keyboard 30 or the mouse 32, the scanning operation start signal is fed from the personal computer 26 to the system control unit 10.

When the receipt of the scanning operation start signal is confirmed, the control proceeds from step 1301 to step 1302, in which a positioning operation for the silicon wafer (SW) is executed by suitably driving the mechanical scanning system 18. Namely, a chip area (CA) on the silicon wafer (SW) is positioned such that a scanning start position (SS) on the chip area (CA) is irradiated with the modulated and focused laser beam MLB. Then, at step 1303, it is monitored whether the positioning operation has been completed.

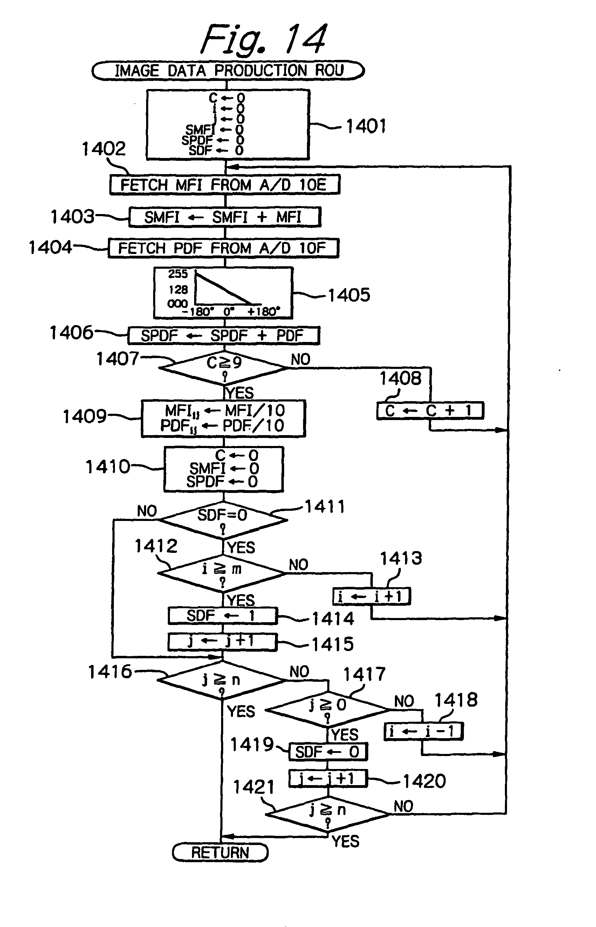

When the completion of the position operation is confirmed, the control proceeds from step 1303 to step 1304, in which an image data production routine is executed to thereby produce and store a frame of mxn magnetic field intensity image pixel data $MFI_{ij}$ and a frame of mxn phase difference image pixel data $PDF_{ij}$ in the RAM 10C of the system control unit 10, as shown in Figs. 5 and 6 by way of example. Note, the image data production routine will be explained in detail with reference to Fig. 14 hereinafter.

At step 1305, the produced frames of mxn image pixel data $MFI_{ij}$ and $PDF_{ij}$ are fed to the personal computer 26 through the I/0 interface circuit 10D of the system control unit 10.

At step 1306, it is determined whether another chip area (CA) to be scanned remains on the silicon wafer (SW). When there is another chip area (CA) on the silicon wafer (SW), the control returns to step 1302, and the routine comprising steps 1302 to 1305 is again executed. Namely, the other chip area (CA) on the silicon wafer (SW) is positioned such that a scanning start position (SS) on the chip area (CA) is irradiated with the modulated and focused laser beam MLB (step 1303), a frame of mxn magnetic field intensity image pixel data $MFI_{ij}$ and a frame of mxn phase difference image pixel data $PDF_{ij}$ on the other chip area (CA) are produced and fed to the personal computer 26 (steps 1304 and 1305).

On the other hand, at step 1306, when no chip area (CA) to be scanned remains on the silicon wafer (SW), the control returns to step 1301, in which it is monitored whether a further scanning-operation start signal is received from the personal computer 26 to analyze and evaluate another silicon wafer (SW).

Figure 14 shows a flowchart of the image data production routine which is executed as a subroutine in step 1304 of the main routine shown in Fig. 13.

At step 1401, an initialization is carried out. Namely, counters c, i and j are initialized to "0", variables SMFI and SPDF are initialized to "0", and a scanning-direction indicating flag SDF is initialized to "0".

Note, as explained with reference to Fig. 4, when the chip area (CA) is scanned with the laser beam MLB in the first scanning direction SD1, a setting of "0" is given to the flag SDF, and, when the chip area (CA) is scanned with the laser beam MLB in the second scanning direction SD2, a setting of "1" is given to the flag SDF.

At step 1402, an 8-bit digital magnetic field intensity image datum MFI is fetched from the A/D converter 10E. Then, at step 1403, the following calculation is carried out:

$$\text{SMFI} \leftarrow \text{SMFI} + \text{MFI}$$

At step 1404, an 8-bit digital phase difference image datum PDF is fetched from the A/D converter 10F. Then, at step 1405, the fetched datum PDF is subjected to a gradation conversion processing, using the one-dimensional map shown in Fig. 7, and, at step 1406, the following calculation is carried out:

$$\text{SPDF} \leftarrow \text{SPDF} + \text{PDF}$$

At step 1407, it is monitored whether a count number of the counter c has reached "9". Since c=0 at the initial stage, the control proceeds from step 1407 to step 1408, in which the count number of the counter c is incremented by "1". Then, the control returns to step 1402, and the routine comprising steps 1402 to 1408 is repeated until the count number of the counter c has reached "9" , i.e. until the respective variables SMFI and SPDF have reached the sums of the consecutive ten magnetic field intensity data MFI and consecutive ten phase difference data PDF.

At step 1407, when it is confirmed that the count number of the counter c has reached "9" , the control proceeds from step 1407 to step 1409, in which the following calculations are carried out:

$$MFI_{ij} \leftarrow SMFI/10$$

$$PDF_{ij} \leftarrow SPDF/10$$

Namely, an image pixel datum $MFI_{ij}$ is defined as an average value of the consecutive ten digital magnetic field intensity data MFI obtained from the magnetic field intensity signal MFI-S, and an image pixel datum $PDF_{ij}$ is defined as an average value of the consecutive ten phase difference data PDF obtained from the phase difference signal PDF-S.

At step 1410, the counter c and the variables SMFI and SPDF are reset to "0" . Then, at step 1411, it is determined whether the scanning-direction indicating flag SDF is equal to "0" or "1" . Since SDF=0 at the initial stage, the control proceeds from step 1411 to step 1412, in which it is monitored whether a count number of the counter i has reached "m" . Note, as is apparent from Figs. 5 and 6, "m" represents a number of image pixels included in a horizontal line of each of the frames of magnetic field intensity and phase difference images ($MFI_{ij}$, $PDF_{ij}$).

Since i=0 at the initial stage, the control proceeds from step 1412 to step 1413, in which the count number of the counter i is incremented by "1" . Then, the control returns to step 1402, and the routine comprising steps 1402 to 1414 is repeated until the count number of the counter c has reached "m" , i.e. until the respective m image pixel data $MFI_{ij}$ and $PDF_{ij}$, included in the horizontal lines of the frames of magnetic field intensity and phase difference images, have been obtained.

At step 1412, when it is confirmed that the count number of the counter i has reached "m" , i.e. that respective two first horizontal lines of image pixel data $MFI_{ij}$ and $PDF_{ij}$ have been produced, the control proceeds from step 1412 to 1414, in which the scanning-direction indicating flag SDF is changed from "0" to "1" . Then, at step 1415, a count number of the counter j is incremented by "1" , and, at step 1416, it is monitored whether the count number of the counter j has reached "n". Note, as is apparent from Figs. 5 and 6, "n" represents a number of the horizontal lines included in each of the frames of magnetic field intensity and phase difference images ($MFI_{ij}$, $PDF_{ij}$).

When the count number of the counter j has not reached "n" , the control proceeds from step 1416 to step 1417, it is monitored whether the count number (m) of the counter i has been decreased to "0" . If j > 0, the control proceeds to step 1418, in which the count number of the counter i is decremented by "1" . Then, the control returns from step 1418 to step 1402, to thereby produce two respective second horizontal lines of image pixel data $MFI_{ij}$ and $PDF_{ij}$. Note, during the production of the two respective second horizontal lines of image pixel data $MFI_{ij}$ and $PDF_{ij}$, the control skips from step 1411 to step 1416, because of SDF=1.

At step 1417, when it is confirmed that the count number of the counter i has been decreased to "0" , i.e. that the two respective second horizontal lines of image pixel data $MFI_{ij}$ and $PDF_{ij}$ have been produced, the control proceeds from step 1417 to step 1419, in which the scanning-direction indicating flag SDF is changed from "1" to "0" . Then, at step 1420, the count number of the counter j is incremented by "1" , and, at step 1421, it is monitored whether the count number of the counter j has reached "n" .

When the count number of the counter j has not reached "n" , the control returns from step 1421 to step 1402, to thereby produce two respective third horizontal lines of image pixel data $MFI_{ij}$ and $PDF_{ij}$. Note, during the production of the two respective third horizontal lines of image pixel data $MFI_{ij}$ and $PDF_{ij}$, the control proceeds from step 1411 to step 1412, because of SDF=0.

At step 1416 or 1421, it is confirmed that the count number of the counter j has reached "n" , i.e. that the chip area (CA) concerned has been completely scanned with the modulated and focused laser beam MLB, the control returns from 1416 or 1421 to step 1305 of the main routine shown in Fig. 13.

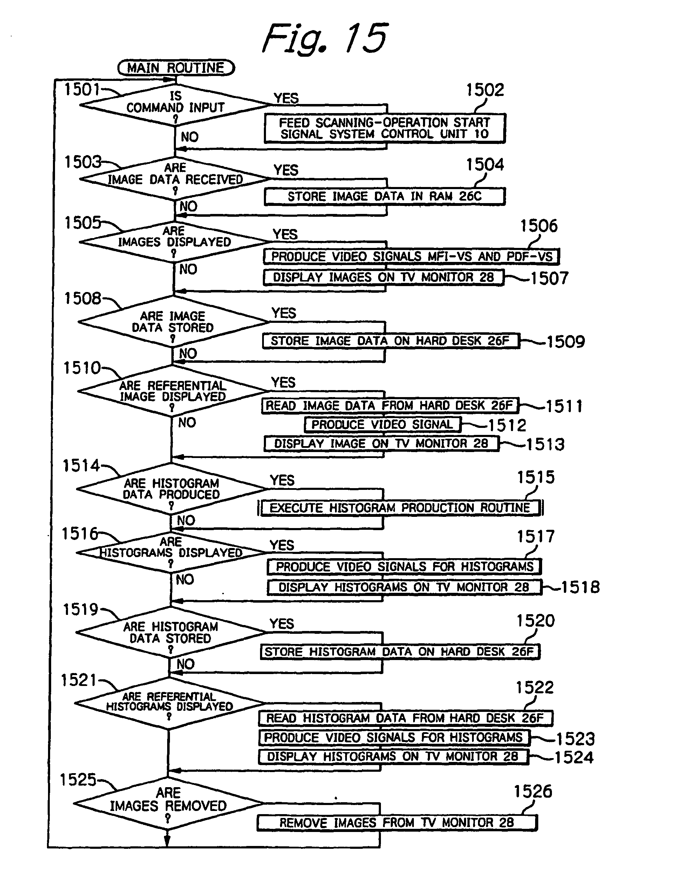

Figure 15 shows a flowchart of a main routine executed in the microprocessor 26A of the personal computer 26.

At step 1501, it is monitored whether a signal feeding command for feeding a scanning operation start signal to the system control unit 10 is input to the microprocessor 26A by manipulating either the keyboard 30 or the mouse 32. When the inputting of the signal feeding command is confirmed, the control proceeds from step 1501 to step 1502, in which the scanning operation start signal is fed to the system control unit 10 (see step 1301 of Fig. 13).

At step 1503, it is monitored whether the personal computer 26 receives two respective frames of m×n image pixel data $MFI_{ij}$ and $PDF_{ij}$ from the system control unit 10 (see step 1305 of Fig. 13). When the receipt of the frames of mxn image pixel data $MFI_{ij}$ and $PDF_{ij}$ from the system control unit 10 is confirmed, the control proceeds to step 1504, in which the frames of image pixel data $MFI_{ij}$ and $PDF_{ij}$ are stored in the RAM 26C of the personal computer 26.

At step 1505, it is monitored whether an image displaying command for displaying respective magnetic field intensity and phase difference images on the TV monitor 28 is input to the microprocessor 26A by manipulating either the keyboard 30 or the mouse 32. When the inputting of the image displaying command is confirmed, the control proceeds from step 1505 to step 1506, in which respective video signals MFI-VS and PDF-VS are produced based on the frames of image pixel data $MFI_{ij}$ and $PDF_{ij}$. Then, at step 1507, a magnetic field intensity image (as shown in Fig. 9A or 9B) and a phase difference image (as shown in Fig. 10A or 10B) are displayed on the TV monitor 28 in accordance with the video signals MFI-VS and PDF-VS. Note, if necessary, only one of the magnetic field intensity image and the phase difference image may be selectively displayed on the TV monitor 28.

At step 1508, it is monitored whether an image data storing command for storing the frames of image pixel data $MFI_{ij}$ and $PDF_{ij}$ on the hard disk 26F is input to the microprocessor 26A by manipulating either the keyboard 30 or the mouse 32. When the inputting of the image data storing command is confirmed, the control proceeds from step 1508 to step 1509, in which the frames of image pixel data $MFI_{ij}$ and $PDF_{ij}$ are stored on the hard disk 26F through the hard disk driver 26E.

At step 1510, it is monitored whether a referential image displaying command for displaying a referential image on the TV monitor 28 is input to the microprocessor 26A by manipulating either the keyboard 30 or the mouse 32. Note, the referential image is derived from a good semiconductor device (see Fig. 9B or 10B), and is previously stored as a frame of image pixel data on the hard disk 26F. When the inputting of the referential image displaying command is confirmed, the control proceeds from step 1510 to step 1511, in which the corresponding frame of image pixel data is read from the hard disk 26F. Then, at step 1512, a video signal is produced based on the read frame of image pixel data, and, at step 1513, an image is displayed as the referential image on the TV monitor 28 in accordance with the produced video signal. For example, when the referential image is a phase difference image, it is possible to compare the phase difference image, displayed at step 1507, with the referential phase difference image, as shown in Figs. 10A and 10B by way of example.

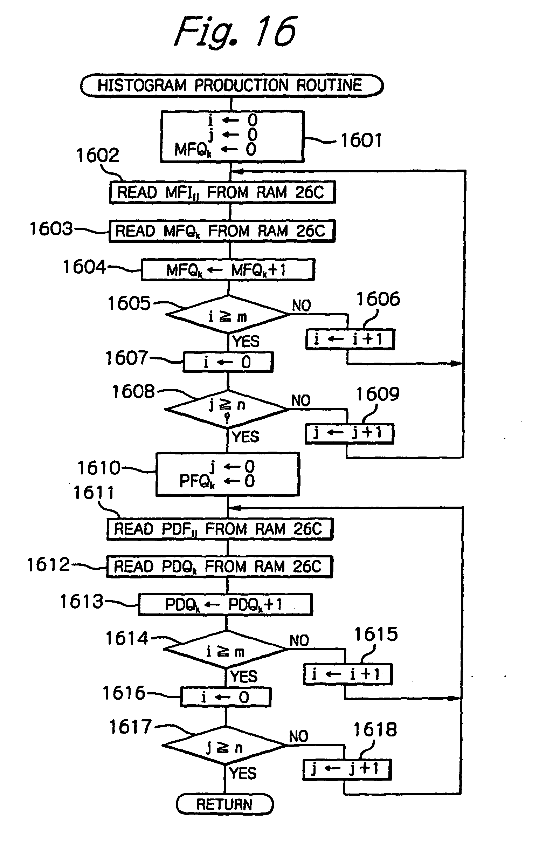

At step 1514, it is monitored whether a histogram producing command for producing respective histogram data from the frames of image pixel data $MFI_{ij}$ and $PDF_{ij}$ is input to the microprocessor 26A by manipulating either the keyboard 30 or the mouse 32. When the inputting of the histogram producing command is confirmed, the control proceeds from step 1514 to step 1515, in which a histogram production routine is executed to thereby produce magnetic field intensity histogram data and phase difference histogram data. Note, the histogram data production routine will be explained in detail with reference to Fig. 16 hereinafter.

At step 1516, it is monitored whether a histogram displaying command for displaying respective magnetic field intensity and phase difference histograms on the TV monitor 28 is input to the microprocessor 26A by manipulating either the keyboard 30 or the mouse 32. When the inputting of the histogram displaying command is confirmed, the control proceeds from step 1516 to step 1517, in which respective video signals for the magnetic field intensity and phase difference histograms are produced based on the aforesaid histogram data. Then, at step 1518, a magnetic field intensity histogram (as shown in Fig. 11A or 11B) and a phase difference histogram (as shown in Fig. 12A or 12B) are displayed on the TV monitor 28 in accordance with the video signals for the magnetic field intensity and phase difference histograms. Note, only one of the magnetic field intensity histogram and the phase difference histogram may be selectively displayed on the TV monitor 28, if necessary.

At step 1519, it is monitored whether a histogram data storing command for storing the aforesaid histogram data on the hard disk 26F is input to the microprocessor 26A by manipulating either the keyboard 30 or the mouse 32. When the inputting of the histogram data storing command is confirmed, the control proceeds from step 1519 to step 1520, in which the histogram data are stored on the hard disk 26F through the hard disk driver 26F.

At step 1521, it is monitored whether a referential histogram displaying command for displaying a referential histogram on the TV monitor 28 is input to the microprocessor 26A by manipulating either the keyboard 30 or the mouse 32. Note, the referential histogram is derived from a good semiconductor device (see Fig. 11B or 12B), and is previously stored as histogram data on the hard disk 26F. When the inputting of the referential histogram displaying command is confirmed, the control proceeds from step 1521 to step 1522, in which the corresponding histogram data is read from the hard disk 26F. Then, at step 1523, a video signal is produced based on the read histogram data, and, at step 1524, a histogram is displayed as the referential histogram on the TV monitor 28 in accordance with the produced video signal for the histogram data. For example, when the referential histogram is a phase difference histogram, it is possible to compare the phase difference histogram, displayed at step 1518, with the referential phase difference image, as shown in Figs. 12A and 12B by way of example.

At step 1525, it is monitored whether an image removing command for removing the displayed images and/or histograms from the TV monitor 28 is input to the microprocessor 26A by manipulating either the keyboard 30 or the mouse 32. When the inputting of the image removing command is confirmed, the control proceeds from step 1525 to step 1526, in which the displayed images and/or histograms are removed from the TV monitor 28.

Namely, in the personal computer 26, it is always monitored to determine whether any of the various commands is input to the microprocessor 26A, and, when the inputting of a command is confirmed, the corresponding processing is carried out.

Figure 16 shows a flowchart of the histogram production routine which is executed as a subroutine in step 1515 of the main routine shown in Fig. 15. Note, for the production of the respective magnetic field intensity and phase difference histogram data, 256 frequencies $MFQ_{k(000,001, \cdots 254, and 255)}$ and 256 frequencies $PDQ_{k(000, 001, \dots 254, and 255)}$ are defined in the RAM 26C of the personal computer 26.

At step 1601, an initialization is carried out. Namely, counters i and j are initialized to "0" , and the 256 frequencies $MFQ_{k(000,001, \dots 254, and 255)}$ are initialized to "0" .

At step 1602, the pixel datum $MFI_{ij}$ is read from the RAM 26C. Then, at step 1603, a frequency $MFQ_k$, corresponding to a density (gradation) level k of the read pixel datum $MFI_{ij}$ is read from the RAM 26C. For example, when the read pixel datum $MFI_{ij}$ features a density level "122" , the frequency $MFQ_{122}$ is read from the RAM 26C.

At step 1604, the following calculation is carried out:

$$MFQ_k \leftarrow MFQ_k + 1$$

At step 1605, it is monitored whether a count number of the counter i has reached "m" . Since i=0 at the initial stage, the control proceeds from step 1605 to step 1606, in which the count number of the counter i is incremented by "1" . Then, the control returns to step 1602, and the routine comprising steps 1602 to 1606 is repeated until the count number of the counter i has reached "m" , i.e. until the image pixel data $MFI_{ij}$ included in the first horizontal line (j=0) has been read from the RAM 26C.

At step 1605, when it is confirmed that the count number of the counter i has reached "m" , the control proceeds from step 1605 to 1607, in which the counter i is reset to "0" . Then, at step 1608, it is monitored whether a count number of the counter j has reached "n" .

Since j=0 at the initial stage, the control proceeds from step 1608 to step 1609, in which the count number of the counter j is incremented by "1" . Then, the control returns to step 1602, and the routine comprising steps 1602 to 1606 is repeated until the count number of the counter i has reached "m" (step 1605), i.e. until the image pixel data $MFI_{ij}$ included in the second horizontal line ( j=1) has been read from the RAM 26C.

At step 1605, when it is confirmed that the count number of the counter i has again reached "m" , i.e. that all the image pixel data $MFI_{ij}$ included in the second horizontal line (j=1) has been read from the RAM 26C, the control proceeds from step 1605 to step 1607. Namely, the routine comprising steps 1602 to 1609 is repeated until the count number of the counter j has reached "n" (step 1608), i.e. until the frame of image pixel data $MFI_{ij}$ has been completely read from the RAM 26C.

Note, when the reading of the frame of image pixel data $MFI_{ij}$ is completed, the 256 frequencies $MFQ_k$ form the aforesaid histogram data for the magnetic field intensity image ($MFI_{ij}$).

At step 1608, when it is confirmed that the count number of the counter j has reached "n" , the control proceeds from step 1608 to 1610, in which the counter j is reset to "0" , and the 256 frequencies $PDQ_{k(000, 001, \dots 254, and 255)}$ are initialized to "0" .

At step 1611, the pixel datum $PDF_{ij}$ is read from the RAM 26C. Then, at step 1612, a frequency $PDQ_k$, corresponding to a density (gradation) level k of the read pixel datum $PDF_{ij}$ is read from the RAM 26C. For example, when the read pixel datum $PDF_{ij}$ features a density level "133" , the frequency $MFQ_{133}$ is read from the RAM 26C.

At step 1613, the following calculation is carried out:

$$PDQ_k \leftarrow PDQ_k + 1$$

At step 1614, it is monitored whether a count number of the counter i has reached "m" . Since i=0 at the initial stage, the control proceeds from step 1614 to step 1615, in which the count number of the counter i is incremented by "1" . Then, the control returns to step 1611, and the routine comprising steps 1602 to 1606 is repeated until the count number of the counter i has reached "m" , i.e. until the image pixel data $PDF_{ij}$ included in the first horizontal line (j=0) has been read from the RAM 26C.

At step 1614, when it is confirmed that the count number of the counter i has reached "m" , the control proceeds from step 1614 to 1616, in which the counter i is reset to "0" . Then, at step 1617, it is monitored whether the count number of the counter j has reached "n".

Since j=0 at the initial stage, the control proceeds from step 1617 to step 1618, in which the count number of the counter j is incremented by "1" . Then, the control returns to step 1611, and the routine comprising steps 1611 to 1615 is repeated until the count number of the counter i has reached "m" (step 1614), i.e. until the image pixel data $PDF_{ij}$ included in the second horizontal line (j=1) has been read from the RAM 26C.

At step 1614, when it is confirmed that the count number of the counter i has again reached "m" , i.e. that all the image pixel data $PDF_{ij}$ included in the second horizontal line (j=1) has been read from the RAM 26C, the control proceeds from step 1614 to step 1616. Namely, the routine comprising steps 1611 to 1618 is repeated until the count number of the counter j has reached "n" (step 1617), i.e. until the frame of image pixel data $PDF_{ij}$ has been completely read from the RAM 26C.

Note, when the reading of the frame of image pixel data $PDF_{ij}$ is completed, the 256 frequencies $PDQ_k$ form the aforesaid histogram data for the phase difference image ($PDF_{ij}$).

At step 1617, when it is confirmed that the count number of the counter j has reached "n", the control returns to step 1515 of the main routine shown in Fig. 15.

In the above-mentioned embodiment, although the X-Y stage 14 is moved with respect to the modulated and focused laser beam MLB to thereby scan the silicon wafer SW with the laser beam MLB, the scanning operation may be carried out by either deflecting the laser beam MLB with respect to the silicon wafer SW or a combination of the movement of the X-Y stage and the deflection of the laser beam MLB.

Also, in the above-mentioned embodiment, although the video signals MFI-VS and PDF-VS are produced in the personal computer 26, the production of the video signals MFI-VS and PDF-VS may be carried out in the system control unit 10, if necessary. Similarly, although the magnetic histogram data are produced in the personal computer 26, the production of the histogram data may be carried out in the system control unit 10, if necessary.

Further, in the above-mentioned embodiment, although the silicon wafer SW is mounted on the X-Y stage 14, a semiconductor device or chip, diced from the silicon wafer SW, may be mounted on the X-Y stage 14.

**Claims**

1. A nondestructive and noncontact analysis system for analyzing and evaluating an object (SW), comprising:

   a light beam generation/modulation apparatus (12) that is adapted to emit a modulated and focused light beam (MLB) to thereby irradiate the object (SW), the modulation of said modulated and focused light beam is adapted to be carried out with a modulation signal (MO-S) synchronized with a reference signal (RE-S) composed of a series of regular pulses;
   a magnetism detection apparatus (22) that is adapted to detect a magnetic field (MF), which is generated by an electric current induced by irradiating said object with said modulated and focused light beam, to thereby produce a magnetic field signal (MF-S);
   said analysis system being **characterised in** further comprising:
   a signal extraction circuit (24) that is adapted to extract a phase difference signal (PDF-S) between said reference signal (RE-S) and said magnetic field signal (MF-S); and
   an image data production system that is adapted to produce phase difference image data ($PDF_{ij}$) based on said phase difference signal (PDF-S).

2. The nondestructive and noncontact analysis system as set forth in claim 1, further comprising a scanning system (14, 18, 20) that is adapted to scan the object with said modulated and focused light beam (MLB), to thereby induce a series of electric currents at spot areas of the object, which are irradiated with said modulated and focused light beam.

3. The nondestructive and noncontact analysis system as set forth in claim 1, wherein said image data production system includes a gradation conversion system (step 1405) that is adapted to convert gradations of said phase difference image data ($PDF_{ij}$) in accordance with a predetermined gradation characteristic.

4. The nondestructive and noncontact analysis system as set forth in claim 1, further comprising an image display system (26, 28; step 1505) that is adapted to display a phase difference image based on said phase difference image data ($PDF_{ij}$).

5. The nondestructive and noncontact analysis system as set forth in claim 1, further comprising an image display system (26, 28; steps 1505 and 1510) that is adapted to display a phase difference image based on said phase difference image data ($PDF_{ij}$) together with a referential phase difference image based on previously-prepared referential phase difference image data.

6. The nondestructive and noncontact analysis system as set forth in claim 1, further comprising an image display system (26, 28; step 1516) that is adapted to display a phase difference , histogram based on said phase difference image data ($PDF_{ij}$).

7. The nondestructive and noncontact analysis system as set forth in claim 1, further comprising an image display system (26, 28; steps 1516 and 1521) that is adapted to display a phase difference histogram based on said phase difference image data ($PDF_{ij}$) together with a referential phase difference histogram based on previously-prepared referential phase difference image data.

8. The nondestructive and noncontact analysis system as set forth in claim 1, wherein said signal extraction circuit (24) is adapted to extract a magnetic field intensity signal (MFI-S) from said magnetic field signal (MF-S) by said signal extraction circuit (24), and said image data production system is adapted to produce a magnetic field intensity image data ($MFI_{ij}$) based on said magnetic field intensity signal (MFI-S).

9. The nondestructive and noncontact analysis system as set forth in claim 8, further comprising an image display system (26, 28; step 1505) that is adapted to display a magnetic field intensity image and a phase difference image based on said magnetic field

intensity image data ($MFI_{ij}$) and said phase difference image data ($PDF_{ij}$), respectively.

10. The nondestructive and noncontact analysis system as set forth in claim 8, further comprising an image display system (26, 28; steps 1505 and 1510) that is adapted to display respective magnetic field intensity and phase difference images based on said magnetic field intensity image and phase difference image data ($MFI_{ij}$ and $PDF_{ij}$) together with respective referential magnetic field intensity and phase differential images based on previously-prepared referential magnetic field intensity image and phase difference image data.

11. The nondestructive and noncontact analysis system as set forth in claim 8, further comprising an image display system (26, 28; step 1516) that is adapted to display respective magnetic field intensity and phase difference histograms based on said magnetic field intensity image and phase difference image data ($MFI_{ij}$ and $PDF_{ij}$), respectively.

12. The nondestructive and noncontact analysis system as set forth in claim 8, further comprising an image display system (26, 28; steps 1516 and 1521) that is adapted to display respective magnetic field intensity and difference histograms based on said magnetic field intensity image and phase difference image data ($MFI_{ij}$ and $PDF_{ij}$), respectively, together with respective referential magnetic field intensity and phase difference histograms based on previously-prepared referential magnetic field intensity histogram and phase difference histogram images.

13. The nondestructive and noncontact analysis system as set forth in claim 1, wherein said modulated and focused light beam (MLB) is emitted as a modulated and focused laser beam from said light beam generation/modulation apparatus (12).

14. The nondestructive and noncontact analysis system as set forth in claim 1, wherein said magnetism detection apparatus (22) includes a SQUID (Superconducting Quantum Interference Device) magnetic sensor to detect said magnetic fields (MF) generated in the object by each of said electric currents.

15. A nondestructive and noncontact analysis method for analyzing and evaluating an object (SW), comprising:

emitting an modulated and focused light beam (MLB) to thereby irradiate the object (SW), the modulation of said modulated and focused light beam being carried out with a modulation signal (MO-S) synchronized with a reference signal (RE-S) composed of a series of regular pulses;

detecting a magnetic field (MF), which is generated by an electric current induced by irradiating said object with said modulated and focused light beam, to thereby produce a magnetic field signal (MF-S);

said analysis method being **characterised in** further comprising:

extracting a phase difference signal (PDF-S) between said reference signal (RE-S) and said magnetic field signal (MF-S); and

producing phase difference image data ($PDF_{ij}$) based on said phase difference signal (PDF-S).

16. The nondestructive and noncontact analysis method as set forth in claim 15, further comprising scanning the object (SW) with said modulated and focused light beam (MLB), to thereby induce a series of electric currents at spot areas of the object, which are irradiated with said modulated and focused light beam.

17. The nondestructive and noncontact analysis method as set forth in claim 15, wherein said phase difference image data ($PDF_{ij}$) is subjected to a gradation conversion processing (step 1405) such that gradations of said phase difference image data ($PDF_{ij}$) are converted in accordance with a predetermined gradation characteristic.

18. The nondestructive and noncontact analysis method as set forth in claim 15, further comprising displaying a phase difference image in an image display system (26, 28; step 1505) based on said phase difference image data ($PDF_{ij}$).

19. The nondestructive and noncontact analysis method as set forth in claim 15, further comprising displaying a phase difference image in an image display system (26, 28; steps 1505 and 1510) based on said phase difference image data ($PDF_{ij}$) together with a referential phase difference image based on previously-prepared referential phase difference image data, whereby said phase difference image can be compared with said referential phase difference image.

20. The nondestructive and noncontact analysis method as set forth in claim 15, further comprising displaying a phase difference histogram in an image display system (26, 28; step 1516) based on said phase difference image data ($PDF_{ij}$).

21. The nondestructive and noncontact analysis method as set forth in claim 15, further comprising displaying a phase difference histogram in an image display system (26, 28; steps 1516 and 1521) based on said phase difference image data ($PDF_{ij}$) together with a referential phase difference histogram based on previously-prepared referential phase difference image data.

22. The nondestructive and noncontact analysis method as set forth in claim 15, further comprising:

extracting a magnetic field intensity signal (MFI-S) from said magnetic field signal (MF-S); and producing magnetic field intensity image data (MFI$_{ij}$) based on said magnetic field intensity signal (MFI-S).

23. The nondestructive and noncontact analysis method as set forth in claim 22, further comprising displaying a magnetic field intensity image and a phase difference image in an image display system (26, 28; step 1505) based on said magnetic field intensity image data (MFI$_{ij}$) and said phase difference image data (PDF$_{ij}$).

24. The nondestructive and noncontact analysis method as set forth in claim 22, further comprising displaying respective magnetic field intensity and phase difference images based on said magnetic field intensity image and phase difference image data (MFI$_{ij}$ and PDF$_{ij}$) together with respective referential magnetic field intensity and phase difference images based on previously-prepared referential magnetic field intensity image and phase difference image data.

25. The nondestructive and noncontact analysis method as set forth in claim 22, further comprising displaying a magnetic field intensity histogram and a phase difference histogram based on said magnetic field intensity image data (MFI$_{ij}$) and said phase difference image data (PDF$_{ij}$), respectively.

26. The nondestructive and noncontact analysis method as set forth in claim 25, further comprising-displaying respective magnetic field intensity and phase difference histograms based on said magnetic field intensity image and phase difference image data (MFI$_{ij}$ and PDF$_{ij}$) together with respective referential magnetic field intensity and phase difference histograms based on previously-prepared magnetic field intensity and phase difference images.

**Patentansprüche**

1. Zerstörungsfreies und berührungsloses Analysesystem zum Analysieren und Auswerten eines Objekts (SW), wobei das System Folgendes aufweist:

eine Lichtstrahlerzeugungs-/modulierungsvorrichtung (12), welche derart ausgelegt ist, dass sie einen modulierten und fokussierten Lichtstrahl (MLB) ausgibt, um somit das Objekt (SW) zu bestrahlen, wobei die Modulation des modulierten und fokussierten Lichtstrahls derart ausgelegt ist, dass sie mit einem Modulationssignal (MO-S) durchgeführt wird, welches mit einem Referenzsignal (RE-S) synchronisiert ist, das aus einer Reihe von regelmäßigen Impulsen besteht;
eine Vorrichtung (22) zur Erfassung von Magnetismus, welche derart ausgelegt ist, dass sie ein Magnetfeld (MF) erfasst, das durch einen elektrischen Strom erzeugt wird, der induziert wird, indem das Objekt mit dem modulierten und fokussierten Lichtstrahl bestrahlt wird, um **dadurch** ein magnetisches Feldsignal (MF-S) zu erzeugen;
wobei das Analysesystem **dadurch gekennzeichnet ist, dass** es des Weiteren Folgendes aufweist:

einen Signalextraktionsschaltkreis (24), der derart ausgelegt ist, dass er ein Phasendifferenzsignal (PDF-S) zwischen dem Referenzsignal (RE-S) und dem Magnetfeldsignal (MF-S) extrahiert; und
ein Bildatenerzeugungssystem, das derart ausgelegt ist, dass es Phasendifferenzbilddaten (PDF$_{ij}$) basierend auf dem Phasendifferenzsignal (PDF-S) erzeugt.

2. Zerstörungsfreies und berührungsloses Analysesystem nach Anspruch 1, welches des Weiteren ein Scannsystem (14, 18, 20) aufweist, das derart ausgelegt, dass es das Objekt mit dem modulierten und fokussierten Lichstrahl (MLB) scannt, um somit eine Reihe von elektrischen Strömen bei Punktbereichen des Objekts, welche mit dem modulierten und fokussierten Lichtstrahl bestrahlt werden, zu induzieren.

3. Zerstörungsfreies und berührungsloses Analysesystem nach Anspruch 1, **dadurch gekennzeichnet, dass** das Bilddatenerzeugungssystem ein Gradationsanpassungssystem (Schritt 1405) aufweist, das derart angepasst ist, dass es Abstufungen der Phasendifferenzbilddaten (PDFij) gemäß einer vorher festgelegten Gradationskennlinie anpasst.

4. Zerstörungsfreies und berührungsloses Analysesystem nach Anspruch 1, welches des Weiteren ein Bildanzeigesystem (26, 28; Schritt 1505) aufweist, das derart ausgelegt ist, dass es ein Phasendifferenzbild basierend auf den Phasendifferenzbilddaten (PDF$_{ij}$) anzeigt.

5. Zerstörungsfreies und berührungsloses Analysesystem nach Anspruch 1, welches des Weiteren ein Bildanzeigesystem (26, 28; Schritte 1505 und 1510) aufweist, das derart ausgelegt ist, dass es ein Phasendifferenzbild basierend auf den Phasendifferenzbilddaten (PDF$_{ij}$) zusammen mit einem Refe-

renzphasendifferenzbild basierend auf zuvor vorbereiteten Referenzphasendifferenzbilddaten anzeigt.

6. Zerstörungsfreies und berührungsloses Analysesystem nach Anspruch 1, welches des Weiteren ein Bildanzeigesystem (26, 28; Schritt 1516) aufweist, das derart ausgelegt ist, dass es ein Phasendifferenzhistogramm basierend auf den Phasendifferenzbilddaten ($PDF_{ij}$) anzeigt.

7. Zerstörungsfreies und berührungsloses Analysesystem nach Anspruch 1, welches des Weiteren ein Bildanzeigesystem (26, 28; Schritte 1516 und 1521) aufweist, das derart ausgelegt ist, dass es ein Phasendifferenzhistogramm basierend auf den Phasendifferenzbilddaten ($PDF_{ij}$) zusammen mit einem Referenzphasendifferenzhistogramm basierend auf zuvor vorbereiteten Referenzphasendifferenzbilddaten anzeigt.

8. Zerstörungsfreies und berührungsloses Analysesystem nach Anspruch 1, **dadurch gekennzeichnet, dass** der Signalextraktionsschaltkreis (24) derart ausgelegt ist, dass er ein Magnetfeldintensitätssignal (MFI-S) von dem Magnetfeldsignal (MF-S) durch den Signalextraktionsschaltkreis extrahiert, und dass das Bilddatenerzeugungssystem derart ausgelegt ist, dass es Magnetfeldintensitätsbilddaten ($MFI_{ij}$) basierend auf dem Magnetfeldintensitätssignal (MFI-S) erzeugt.

9. Zerstörungsfreies und berührungsloses Analysesystem nach Anspruch 8, welches des Weiteren ein Bildanzeigesystem (26, 28; Schritt 1505) aufweist, das derart ausgelegt ist, dass es ein Magnetfeldintensitätsbild und ein Phasendifferenzbild basierend auf den Magnetfeldintensitätsbilddaten ($MFI_{ij}$) bzw. den Phasendifferenzbilddaten ($PDF_{ij}$) anzeigt.

10. Zerstörungsfreies und berührungsloses Analysesystem nach Anspruch 8, welches des Weiteren ein Bildanzeigesystem (26, 28; Schritte 1505 und 1510) aufweist, das derart ausgelegt ist, dass es entsprechende Magnetfeldintensitäts- und Phasendifferenzbilder basierend auf den Magnetfeldintensitätsbilddaten ($MFI_{ij}$) bzw. Phasendifferenzbilddaten ($PDF_{ij}$) zusammen mit entsprechenden Referenzmagnetfeldintensitäts- und Referenzphasendifferenzbildern basierend auf zuvor vorbereiteten Referenzmagnetfeldintensitätsbild- und Referenzphasendifferenzbilddaten anzeigt.

11. Zerstörungsfreies und berührungsloses Analysesystem nach Anspruch 8, welches des Weiteren ein Bildanzeigesystem (26, 28; Schritt 1516) aufweist, das derart ausgelegt ist, dass es entsprechende Magnetfeldintensitäts- und Phasendifferenzhistogramme basierend auf den Magnetfeldintensitätsbild-

bzw. Phasendifferenzbilddaten ($MFI_{ij}$ und $PDF_{ij}$) anzeigt.

12. Zerstörungsfreies und berührungsloses Analysesystem nach Anspruch 8, welches des Weiteren ein Bildanzeigesystem (26, 28; Schritte 1516 und 1521) aufweist, das derart ausgelegt ist, dass es entsprechende Magnetfeldintensitäts- und Differenzhistogramme basierend auf den Magnetfeldintensitätsbild- bzw. Phasendifferenzbilddaten ($MFI_{ij}$ und $PDF_{ij}$) zusammen mit entsprechenden Referenzmagnetfeldintensitäts- und Referenzphasendifferenzhistogrammen basierend auf zuvor vorbereiteten Referenzmagnetfeldintensitätshistogramm- und Referenzphasendifferenzhistogrammbildern anzeigt.

13. Zerstörungsfreies und berührungsloses Analysesystem nach Anspruch 1, **dadurch gekennzeichnet, dass** der modulierte und fokussierte Lichtstrahl (MLB) als ein modulierter und fokussierter Laserstrahl von der Lichtstrahlerzeugungs-/modulationsvorrichtung (12) ausgegeben wird.

14. Zerstörungsfreies und berührungsloses Analysesystem nach Anspruch 1, **dadurch gekennzeichnet, dass** die Magneterfassungsvorrichtung (22) einen SQUID bzw. Superconducting Quantum Interference Device-Magnetsensor aufweist, um die in dem Objekt von jedem der elektrischen Ströme erzeugten Magnetfelder (MF) zu erfassen.

15. Zerstörungsfreies und berührungsloses Analyseverfahren zum Analysieren und Auswerten eines Objekts (SW), welches folgende Schritte umfasst:

Ausgeben eines modulierten und fokussierten Lichtstrahls (MLB), um somit das Objekt (SW) zu bestrahlen, wobei die Modulation des modulierten und fokussierten Lichtstrahls mit einem Modulationssignal (MO-S) durchgeführt wird, das mit einem Referenzsignal (RE-S) synchronisiert wird, das aus einer Reihe von regelmäßigen Impulsen besteht;
Erfassen eines Magnetfeldes (MF), das durch einen elektrischen Strom erzeugt wird, der induziert wird, indem das Objekt mit dem modulierten und fokussierten Lichtstrahl bestrahlt wird, um somit ein Magnetfeldsignal (MF-S) zu erzeugen;
wobei das Analyseverfahren **dadurch gekennzeichnet ist, dass** es des Weiteren folgende Schritte umfasst:
Extrahieren eines Phasendifferenzsignals (PDF-S) zwischen dem Referenzsignal (RE-S) und dem Magnetfeldsignal (MF-S); und
Erzeugen von Phasendifferenzbilddaten ($PDF_{ij}$) basierend auf dem Phasendifferenzsignal (PDF-S).

16. Zerstörungsfreies und berührungsloses Analyseverfahren nach Anspruch 15, welches des Weiteren das Scannen des Objekts (SW) mit dem modulierten und fokussierten Lichtstrahl (MLB) aufweist, um somit eine Reihe von elektrischen Strömen bei Punktbereichen des Objekts zu induzieren, welche mit dem modulierten und fokussierten Lichtstrahl bestrahlt werden.

17. Zerstörungsfreies und berührungsloses Analyseverfahren nach Anspruch 15, **dadurch gekennzeichnet, dass** die Phasendifferenzbilddaten (PDF$_{ij}$) einer Gradationsanpassungsverarbeitung (Schritt 1405) unterzogen wird, so dass Abstufungen der Phasendifferenzbilddaten (PDF$_{ij}$) gemäß einem vorher festgelegten Gradationskennlinie angepasst werden.

18. Zerstörungsfreies und berührungsloses Analyseverfahren nach Anspruch 15, welches des Weiteren die Anzeige eines Phasendifferenzbildes in einem Bildanzeigesystem (26, 28; Schritt 1505) basierend auf den Phasendifferenzbilddaten (PDF$_{ij}$) aufweist.

19. Zerstörungsfreies und berührungsloses Analyseverfahren nach Anspruch 15, welches des Weiteren die Anzeige eines Phasendifferenzbildes in einem Bildanzeigesystem (26, 28; Schritte 1505 und 1510) basierend auf den Phasendifferenzbilddaten (PDF$_{ij}$) zusammen mit einem Referenzphasendifferenzbild basierend auf zuvor vorbereiteten Referenzphasendifferenzbilddaten aufweist, wobei das Phasendifferenzbild mit dem Referenzphasendifferenzbild verglichen werden kann.

20. Zerstörungsfreies und berührungsloses Analyseverfahren nach Anspruch 15, welches des Weiteren die Anzeige eines Phasendifferenzhistogramms in einem Bildanzeigesystem (26, 28; Schritt 1516) basierend auf den Phasendifferenzbilddaten (PDF$_{ij}$) aufweist.

21. Zerstörungsfreies und berührungsloses Analyseverfahren nach Anspruch 15, welches des Weiteren die Anzeige eines Phasendifferenzhistogramms in einem Bildanzeigesystem (26, 28; Schritte 1516 und 1521) basierend auf den Phasendifferenzbilddaten (PDFij) zusammen mit einem Referenzphasendifferenzhistogramm basierend auf zuvor vorbereiteten Referenzphasendifferenzbilddaten aufweist.

22. Zerstörungsfreies und berührungsloses Analyseverfahren nach Anspruch 15, welches des Weiteren folgende Schritte umfasst:

Extrahieren eines Magnetfeldintensitätssignals (MFI-S) von dem Magnetfeldsignal (MF-S); und Erzeugen von Magnetfeldintensitätsbilddaten (MFI$_{ij}$) basierend auf dem Magnetfeldintensitätssignal (MFI-S).

23. Zerstörungsfreies und berührungsloses Analyseverfahren nach Anspruch 22, welches des Weiteren die Anzeige eines Magnetfeldintensitätbildes und eines Phasendifferenzbildes in einem Bildanzeigesystem (26, 28; Schritt 1505) basierend auf den Magnetfeldintensitätsbilddaten (MFI$_{ij}$) und dem Phasendifferenzbilddaten (PDF$_{ij}$) aufweist.

24. Zerstörungsfreies und berührungsloses Analyseverfahren nach Anspruch 22, welches des Weiteren die Anzeige entsprechender Magnetfeldintensitäts- und Phasendifferenzbilder basierend auf den Magnetfeldintensitätsbild- und Phasendifferenzbilddaten (MFI$_{ij}$ und PDF$_{ij}$) zusammen mit entsprechenden Referenumagnetfeldintensitäts- und Referenzphasendifferenzbildern basierend auf zuvor vorbereiteten Referenzmagnetfeldintensitätsbild- und Referenzphasendifferenzbilddaten aufweist.

25. Zerstörungsfreies und berührungsloses Analyseverfahren nach Anspruch 22, welches des Weiteren die Anzeige eines Magnetfeldintensitäthistogramms und eines Phasendifferenzhistogramms basierend auf den Magnetfeldintensitätsbilddaten (MFI$_{ij}$) bzw. den Phasendifferenzbilddaten (PDF$_{ij}$) aufweist.

26. Zerstörungsfreies und berührungsloses Analyseverfahren nach Anspruch 25, welches des Weiteren die Anzeige entsprechender Magnetfeldintensitäts- und Phasendifferenzhistogramme basierend auf den Magnetfeldintensitätsbild- und Phasendifferenzbilddaten (MFI$_{ij}$ und PDF$_{ij}$) zusammen mit entsprechenden Referenzmagnetfeldintensitäts- und Referenzphasendifferenzhistogrammen basierend auf zuvor vorbereiteten Magnetfeldintensitäs- und Phasendifferenzbildern aufweist.

## Revendications

1. Système d'analyse non destructive et sans contact destiné à analyser et évaluer un objet (SW), comprenant :

un appareil de génération/modulation de faisceau lumineux (12) qui est adapté pour émettre un faisceau lumineux focalisé et modulé (MLB) afin d'irradier de cette façon l'objet (SW), la modulation dudit faisceau lumineux focalisé et modulé est adaptée pour être exécutée avec un signal de modulation (MO-S) synchronisé avec un signal de référence (RE-S) composé d'une série d'impulsions régulières ;

un appareil de détection de magnétisme (22) qui est adapté pour détecter un champ magnétique (MF) qui est généré par un courant électrique induit en irradiant ledit objet avec ledit faisceau lumineux focalisé et modulé afin de produire de cette façon un signal de champ magnétique (MF-S) ; ledit système d'analyse étant **caractérisé en ce qu'**il comprend en outre :

un circuit d'extraction de signaux (24) qui est adapté pour extraire un signal de différence de phase (PDF-S) entre ledit signal de référence (RE-S) et ledit signal de champ magnétique (MF-S) ; et

un système de production de données d'image qui est adapté pour produire des données d'image de différence de phase (PDF$_{ij}$) basées sur ledit signal de différence de phase (PDF-S).

2. Système d'analyse non destructive et sans contact selon la revendication 1, comprenant en outre un système de balayage (14, 18, 20) qui est adapté pour balayer l'objet avec ledit faisceau lumineux focalisé et modulé (MLB) afin d'induire de cette façon une série de courants électriques dans des zones ponctuelles de l'objet qui sont irradiées par ledit faisceau lumineux focalisé et modulé.

3. Système d'analyse non destructive et sans contact selon la revendication 1, dans lequel ledit système de production de données d'image comporte un système de conversion de gradation (étape 1405) qui est adapté pour convertir des gradations desdites données d'image de différence de phase (PDF$_{ij}$) conformément à une caractéristique de gradation prédéterminée.

4. Système d'analyse non destructive et sans contact selon la revendication 1, comprenant en outre un système d'affichage d'image (26, 28 ; étape 1505) qui est adapté pour afficher une image de différence de phase basée sur lesdites données d'image de différence de phase (PDF$_{ij}$) .

5. Système d'analyse non destructive et sans contact selon la revendication 1, comprenant en outre un système d'affichage d'image (26, 28 ; étapes 1505 et 1510) qui est adapté pour afficher une image de différence de phase basée sur lesdites données d'image de différence de phase (PDF$_{ij}$) conjointement à une image de différence de phase de référence basée sur des données d'image de différence de phase de référence préparées auparavant.

6. Système d'analyse non destructive et sans contact selon la revendication 1, comprenant en outre un système d'affichage d'image (26, 28 ; étape 1516) qui est adapté pour afficher un histogramme de différence de phase basé sur lesdites données d'image de différence de phase (PDF$_{ij}$).

7. Système d'analyse non destructive et sans contact selon la revendication 1, comprenant en outre un système d'affichage d'image (26, 28 ; étapes 1516 et 1521) qui est adapté pour afficher un histogramme de différence de phase basé sur lesdites données d'image de différence de phase (PDF$_{ij}$) ainsi qu'un histogramme de différence de phase de référence basé sur des données d'image de différence de phase de référence préparées auparavant.

8. Système d'analyse non destructive et sans contact selon la revendication 1, dans lequel ledit circuit d'extraction de signaux (24) est adapté pour extraire un signal d'intensité de champ magnétique (MFI-S) à partir dudit signal de champ magnétique (MF-S) par ledit circuit d'extraction de signaux (24), et ledit système de production de données d'image est adapté pour produire des données d'image d'intensité de champ magnétique (MFI$_{ij}$) basées sur ledit signal d'intensité de champ magnétique (MFI-S).

9. Système d'analyse non destructive et sans contact selon la revendication 8, comprenant en outre un système d'affichage d'image (26, 28 ; étape 1505) qui est adapté pour afficher une image d'intensité de champ magnétique et une image de différence de phase basées respectivement sur lesdites données d'image d'intensité de champ magnétique (MFI$_{ij}$) et sur lesdites données d'image de différence de phase (PDF$_{ij}$) .

10. Système d'analyse non destructive et sans contact selon la revendication 8, comprenant en outre un système d'affichage d'image (26, 28 ; étapes 1505 et 1510) qui est adapté pour afficher des images respectives d'intensité de champ magnétique et de différence de phase basées sur lesdites données d'image d'intensité de champ magnétique et d'image de différence de phase (MFI$_{ij}$ et PDF$_{ij}$) ainsi que des images respectives d'intensité de champ magnétique et de différence de phase de référence basées sur des données d'image d'intensité de champ magnétique et d'image de différence de phase de référence préparées auparavant.

11. Système d'analyse non destructive et sans contact selon la revendication 8, comprenant en outre un système d'affichage d'image (26, 28 ; étape 1516) qui est adapté pour afficher des histogrammes respectifs d'intensité de champ magnétique et de différence de phase basés respectivement sur lesdites données d'image d'intensité de champ magnétique et d'image de différence de phase (MFI$_{ij}$ et (PDF$_{ij}$) .

**12.** Système d'analyse non destructive et sans contact selon la revendication 8, comprenant en outre un système d'affichage d'image (26, 28 ; étapes 1516 et 1521) qui est adapté pour afficher des histogrammes respectifs d'intensité de champ magnétique et de différence de phase basés respectivement sur lesdites données d'image d'intensité de champ magnétique et d'image de différence de phase (MFI$_{ij}$ et PDF$_{ij}$), ainsi que des histogrammes respectifs d'intensité de champ magnétique et de différence de phase de référence basés sur des images d'histogramme d'intensité de champ magnétique et de différence de phase de référence préparées auparavant.

**13.** Système d'analyse non destructive et sans contact selon la revendication 1, dans lequel ledit faisceau lumineux focalisé et modulé (MLB) est émis sous forme d'un faisceau laser modulé et focalisé à partir dudit appareil de génération/modulation de faisceau lumineux (12).

**14.** Système d'analyse non destructive et sans contact selon la revendication 1, dans lequel ledit appareil de détection de magnétisme (22) comporte un capteur magnétique SQUID (dispositif d'interférence quantique supraconducteur) pour détecter lesdits champs magnétiques (MF) générés dans l'objet par chacun desdits courants électriques.

**15.** Procédé d'analyse sans contact et non destructive destiné à analyser et évaluer un objet (SW), comprenant :

l'émission d'un faisceau lumineux focalisé et modulé (MLB) afin d'irradier de cette façon l'objet (SW), la modulation dudit faisceau lumineux focalisé et modulé étant exécutée avec un signal de modulation (MO-S) synchronisé avec un signal de référence (RE-S) composé d'une série d'impulsions régulières ;
la détection d'un champ magnétique (MF) qui est généré par un courant électrique induit en irradiant ledit objet avec ledit faisceau lumineux focalisé et modulé, afin de produire de cette façon un signal de champ magnétique (MF-S) ;
ledit procédé d'analyse étant **caractérisé en ce qu'**il comprend en outre :

l'extraction d'un signal de différence de phase (PDF-S) entre ledit signal de référence (RE-S) et ledit signal de champ magnétique (MF-S) et
la production de données d'image de différence de phase (PDF$_{ij}$) basées sur ledit signal de différence de phase (PDF-S).

**16.** Procédé d'analyse sans contact et non destructive selon la revendication 15, comprenant en outre le balayage de l'objet (SW) avec ledit faisceau lumineux focalisé et modulé (MLB), afin d'induire de cette façon une série de courants électriques en des zones ponctuelles de l'objet qui sont irradiées avec ledit faisceau lumineux focalisé et modulé.

**17.** Procédé d'analyse sans contact et non destructive selon la revendication 15, dans lequel lesdites données d'image de différence de phase (PDF$_{ij}$) sont soumises à un traitement de conversion de gradation (étape 1405) de manière que des gradations desdites données d'image de différence de phase (PDF$_{ij}$) soient converties conformément à une caractéristique de gradation prédéterminée.

**18.** Procédé d'analyse sans contact et non destructive selon la revendication 15, comprenant en outre un affichage d'une image de différence de phase dans un système d'affichage d'image (26, 28 ; étape 1505) basé sur lesdites données d'image de différence de phase (PDF$_{ij}$) .

**19.** Procédé d'analyse sans contact et non destructive selon la revendication 15, comprenant en outre un affichage d'une image de différence de phase dans un système d'affichage d'image (26, 28 ; étapes 1505 et 1510) basé sur lesdites données d'image de différence de phase (PDF$_{ij}$) ainsi que d'une image de différence de phase de référence basée sur des données d'image de différence de phase de référence préparées auparavant, moyennant quoi ladite image de différence de phase peut être comparée à ladite image de différence de phase de référence.

**20.** Procédé d'analyse sans contact et non destructive selon la revendication 15, comprenant en outre un affichage d'un histogramme de différence de phase dans un système d'affichage d'image (26, 28 ; étape 1516) basé sur lesdites données d'image de différence de phase (PDF$_{ij}$).

**21.** Procédé d'analyse sans contact et non destructive selon la revendication 15, comprenant en outre un affichage d'un histogramme de différence de phase dans un système d'affichage d'image (26, 28 ; étapes 1516 et 1521) basé sur lesdites données d'image de différence de phase (PDF$_{ij}$) ainsi qu'un histogramme de différence de phase de référence basé sur des données d'image de différence de phase de référence préparées auparavant.

**22.** Procédé d'analyse sans contact et non destructive selon la revendication 15, comprenant en outre :

l'extraction d'un signal d'intensité de champ magnétique (MFI-S) à partir dudit signal de champ magnétique (MF-S) ; et

la production de données d'image d'intensité de champ magnétique (MFI$_{ij}$) basées sur ledit signal d'intensité de champ magnétique (MFI-S).

23. Procédé d'analyse sans contact et non destructive selon la revendication 22, comprenant en outre un affichage d'une image d'intensité de champ magnétique et d'une image de différence de phase dans un système d'affichage d'image (26, 28 ; étape 1505) basé sur lesdites données d'image d'intensité de champ magnétique (MFI$_{ij}$) et sur lesdites données d'image de différence de phase (PDF$_{ij}$).

24. Procédé d'analyse sans contact et non destructive selon la revendication 22, comprenant en outre un affichage des images respectives d'intensité de champ magnétique et de différence de phase basées sur lesdites données d'image d'intensité de champ magnétique et d'image de différence de phase (MFI$_{ij}$ et PDF$_{ij}$) ainsi que des images respectives d'intensité de champ magnétique et de différence de phase de référence basées sur des données d'images d'intensité de champ magnétique et de différence de phase de référence préparées auparavant.

25. Procédé d'analyse sans contact et non destructive selon la revendication 22, comprenant en outre un affichage d'un histogramme d'intensité de champ magnétique et d'un histogramme de différence de phase basés respectivement sur lesdites données d'image d'intensité de champ magnétique (MFI$_{ij}$) et lesdites données d'image de différence de phase (PDF$_{ij}$) .

26. Procédé d'analyse sans contact et non destructive selon la revendication 25, comprenant en outre un affichage des histogrammes respectifs d'intensité de champ magnétique et de différence de phase basés sur lesdites données d'image d'intensité de champ magnétique et d'image de différence de phase (MFI$_{ij}$ et PDF$_{ij}$) ainsi que des histogrammes respectifs d'intensité de champ magnétique et de différence de phase de référence basés sur des images d'intensité de champ magnétique et de différence de phase préparées auparavant.

# Fig. 1

Labels in figure: 28, 26, 10 SYSTEM CONTROL UNIT, MFI$_{ij}$, PDF$_{ij}$, 24 SIGNAL EXTRACTION CIRCUIT, MFI-S, PDF-S, MF-S, 20 DRIVER CIRCUIT, 18 MECHANICAL SCANNING SYSTEM, 22 MAGNETISM DETECTION APPARATUS, 22B SQUID C/P CIRCUIT, 22A SQUID SENSOR, SQ-S, 14, MF, MLB, 16, X, Y, 12 LASER BEAM G/M APPARATUS, 12A LASER BEAM GENERATOR, 12B REFERENCE SIGNAL GENERATOR, 12C OPTICAL UNIT, 12D, MO-S, RE-S

## Fig. 2

```
                         10
        ┌ ─ ─ ─ ─ ─ ─ ─ ─ ─ ─ ─ ─ ─ ┐
        │  SYSTEM CONTROL UNIT        │
FROM 24B│     10E            10A      │
  MFI-S │  ┌─────┐        ┌─────┐     │
        ├─→│ A/D │◄──────►│ CPU │     │
FROM 24C│  └─────┘        └─────┘     │
        │     10F            10B      │
  PDF-S │  ┌─────┐        ┌─────┐     │
        ├─→│ A/D │◄──────►│ ROM │     │
        │  └─────┘        └─────┘     │
        │     10D            10C      │
 TO 20 ◄┤  ┌─────┐        ┌─────┐     │
        │  │  A  │        │ RAM │     │
TO 12A ◄┤◄─│  /  │◄──────►└─────┘     │
        │  │  D  │                    │
TO 12B ◄┤◄─└─────┘                    │
        │      ▲        MFIᵤ  TO 26D  │
        │      │        PDFᵤ          │
        │      └──────────── FROM 26D │
        └ ─ ─ ─ ─ ─ ─ ─ ─ ─ ─ ─ ─ ─ ┘
```

## Fig. 3

```
          Δφ
        ├─→│
MFI-S   ┌─┐ ┌─┐ ┌─┐ ┌─┐ ┌─┐ ┌─┐ ┌─┐
      ──┘ └─┘ └─┘ └─┘ └─┘ └─┘ └─┘ └─

RE-S    ┌─┐ ┌─┐ ┌─┐ ┌─┐ ┌─┐ ┌─┐ ┌─┐
      ──┘ └─┘ └─┘ └─┘ └─┘ └─┘ └─┘ └─

MD-S    ┌─┐ ┌─┐ ┌─┐ ┌─┐ ┌─┐ ┌─┐ ┌─┐
      ──┘ └─┘ └─┘ └─┘ └─┘ └─┘ └─┘ └─
```

## Fig. 4

## Fig. 5

| j \ i | 0 | 1 | 2 | --------- | m−3 | m−2 | m−1 |
|---|---|---|---|---|---|---|---|
| 0 | $MFI_{00}$ | $MFI_{10}$ | $MFI_{20}$ | --------- | $MFI_{(m-3)0}$ | $MFI_{(m-2)0}$ | $MFI_{(m-1)0}$ |
| 1 | $MFI_{01}$ | $MFI_{11}$ | $MFI_{21}$ | --------- | $MFI_{(m-3)1}$ | $MFI_{(m-2)1}$ | $MFI_{(m-1)1}$ |
| 2 | $MFI_{02}$ | $MFI_{12}$ | $MFI_{22}$ | --------- | $MFI_{(m-3)2}$ | $MFI_{(m-2)2}$ | $MFI_{(m-1)2}$ |
| ⋮ | ⋮ | ⋮ | ⋮ | | ⋮ | ⋮ | ⋮ |
| n−3 | $MFI_{0(n-3)}$ | $MFI_{1(n-3)}$ | $MFI_{2(n-3)}$ | --------- | $MFI_{(m-3)(n-3)}$ | $MFI_{(m-2)(n-3)}$ | $MFI_{(m-1)(n-3)}$ |
| n−2 | $MFI_{0(n-2)}$ | $MFI_{1(n-2)}$ | $MFI_{2(n-2)}$ | --------- | $MFI_{(m-3)(n-2)}$ | $MFI_{(m-2)(n-2)}$ | $MFI_{(m-1)(n-2)}$ |
| n−1 | $MFI_{0(n-1)}$ | $MFI_{1(n-1)}$ | $MFI_{2(n-1)}$ | --------- | $MFI_{(m-3)(n-1)}$ | $MFI_{(m-2)(n-1)}$ | $MFI_{(m-1)(n-1)}$ |

## Fig. 6

| j\i | 0 | 1 | 2 | ---------- | m−3 | m−2 | m−1 |
|-----|---|---|---|------------|------|------|------|
| 0 | $PDF_{00}$ | $PDF_{10}$ | $PDF_{20}$ | ---------- | $PDF_{(m-3)0}$ | $PDF_{(m-2)0}$ | $PDF_{(m-1)0}$ |
| 1 | $PDF_{01}$ | $PDF_{11}$ | $PDF_{21}$ | ---------- | $PDF_{(m-3)1}$ | $PDF_{(m-2)1}$ | $PDF_{(m-1)1}$ |
| 2 | $PDF_{02}$ | $PDF_{12}$ | $PDF_{22}$ | ---------- | $PDF_{(m-3)2}$ | $PDF_{(m-2)2}$ | $PDF_{(m-1)2}$ |
| ⋮ | ⋮ | ⋮ | ⋮ | ---+--- | ⋮ | ⋮ | ⋮ |
| n−3 | $PDF_{0(n-3)}$ | $PDF_{1(n-3)}$ | $PDF_{2(n-3)}$ | ---------- | $PDF_{(m-3)(n-3)}$ | $PDF_{(m-2)(n-3)}$ | $PDF_{(m-1)(n-3)}$ |
| n−2 | $PDF_{0(n-2)}$ | $PDF_{1(n-2)}$ | $PDF_{2(n-2)}$ | ---------- | $PDF_{(m-3)(n-2)}$ | $PDF_{(m-2)(n-2)}$ | $PDF_{(m-1)(n-2)}$ |
| n−1 | $PDF_{0(n-1)}$ | $PDF_{1(n-1)}$ | $PDF_{2(n-1)}$ | ---------- | $PDF_{(m-3)(n-1)}$ | $PDF_{(m-2)(n-1)}$ | $PDF_{(m-1)(n-1)}$ |

## Fig. 7

BLACK LEVEL 255

INTERMEDIATE GRAY LEVE 128

WHITE LEVEL 000

−180°    0°    +180° ($PDF_{ij}$)

*Fig. 8*

PERSONAL COMPUTER

26

TV MONITOR
28

MFI-VS
PDF-VS

FROM 10D
MFI$_{ij}$
PDF$_{ij}$

TO 10D

I/O
26D

ROM
26B

RAM
26C

MICRO PROCESSOR
26A

HARD DISK DRIVE
26E

26F

KEYBOARD
30

MOUSE
32

# Fig. 9A

DT1

# Fig. 9B

GT1

# Fig. 10A

DT2

# Fig. 10B

GD2

## Fig. 11A

FREQUENCY (PIXEL NUMBER)

| 000 | 128 | 255 |
| WHITE LEVEL | INTERMEDIATE GRAY LEVEL | BLACK LEVEL |

## Fig. 11B

FREQUENCY (PIXEL NUMBER)

| 000 | 128 | 255 |
| WHITE LEVEL | INTERMEDIATE GRAY LEVEL | BLACK LEVEL |

## *Fig. 12A*

FREQUENCY (PIXEL NUMBER)

|  | 400 |  | DC2₁ |  |  | DC2₂ |  |  |
|--|--|--|--|--|--|--|--|--|

WHITE LEVEL (-180°)  INTERMEDIATE GRAY LEVEL  BLACK LEVEL (+180°)

000   128   255

## *Fig. 12B*

FREQUENCY (PIXEL NUMBER)

000   128   255

WHITE LEVEL (-180°)  INTERMEDIATE GRAY LEVEL (0°)  BLACK LEVEL (+180°)

# Fig. 13

```
                  ┌──────────────────────┐
                  │     MAIN ROUTINE      │
                  └──────────────────────┘
                              │
                              ▼                    1301
              ╱───────────────────────────╲
      NO     ╱         IS START            ╲
    ◄────────╲      SIGNAL RECEIVED         ╱
              ╲             ?              ╱
               ╲───────────────────────────╱
                              │ YES
                              ▼                    1302
                  ┌──────────────────────────────┐
                  │ EXECUTE POSITIONING OPERATION │
                  └──────────────────────────────┘
                              │
                              ▼                    1303
              ╱───────────────────────────╲
      NO     ╱       IS POSITIONING         ╲
    ◄────────╲    OPERATION COMPLETED        ╱
              ╲             ?               ╱
               ╲───────────────────────────╱
                              │ YES
                              ▼                    1304
                ┌────────────────────────────────────┐
                ║ EXECUTE IMAGE DATA PRODUCTION ROUTINE ║
                └────────────────────────────────────┘
                              │                    1305
                              ▼
                ┌────────────────────────────────────┐
                │ FEED IMAGE DATA TO PERSONAL COMPUTER 26 │
                └────────────────────────────────────┘
                              │                    1306
                              ▼
              ╱───────────────────────────╲   NO
              ╲          REMAINS            ╱────────►
               ╲            ?             ╱
                ╲─────────────────────────╱
                              │ YES
```

## Fig. 14

IMAGE DATA PRODUCTION ROU

1401
C ← 0
i ← 0
j ← 0
SMFI ← 0
SPDF ← 0
SDF ← 0

1402 — FETCH MFI FROM A/D 10E

1403 — SMFI ← SMFI + MFI

1404 — FETCH PDF FROM A/D 10F

1405
255
128
000
−180°  0°  +180°

1406 — SPDF ← SPDF + PDF

1407 — C ≧ 9 ?   NO →   1408   C ← C + 1

YES

1409 —
MFI$_{ij}$ ← MFI/10
PDF$_{ij}$ ← PDF/10

1410 —
C ← 0
SMFI ← 0
SPDF ← 0

1411   NO ← SDF = 0 ?

YES

1412   i ≧ m ?   NO →   1413   i ← i + 1

YES

SDF ← 1 — 1414

j ← j + 1 — 1415

1416 — j ≧ n ?   NO →   1417   j ≧ 0 ?   NO →   1418   i ← i − 1

YES   YES

1419 — SDF ← 0

i ← i + 1 — 1420

1421 — j ≧ n ?   NO

YES

RETURN

# Fig. 15

MAIN ROUTINE

1501 — IS COMMAND INPUT ?
YES → 1502 — FEED SCANNING-OPERATION START SIGNAL SYSTEM CONTROL UNIT 10
NO

1503 — ARE IMAGE DATA RECEIVED ?
YES → 1504 — STORE IMAGE DATA IN RAM 26C
NO

1505 — ARE IMAGES DISPLAYED ?
YES → 1506 — PRODUCE VIDEO SIGNALS MFI-VS AND PDF-VS
DISPLAY IMAGES ON TV MONITOR 28 —1507
NO

1508 — ARE IMAGE DATA STORED ?
YES → STORE IMAGE DATA ON HARD DESK 26F —1509
NO

1510 — ARE REFERENTIAL IMAGE DISPLAYED ?
YES → READ IMAGE DATA FROM HARD DESK 26F —1511
PRODUCE VIDEO SIGNAL —1512
DISPLAY IMAGE ON TV MONITOR 28 —1513
NO

1514 — ARE HISTOGRAM DATA PRODUCED ?
YES → 1515 — EXECUTE HISTOGRAM PRODUCTION ROUTINE
NO

1516 — ARE HISTOGRAMS DISPLAYED ?
YES → 1517 — PRODUCE VIDEO SIGNALS FOR HISTOGRAMS
DISPLAY HISTOGRAMS ON TV MONITOR 28 —1518
NO

1519 — ARE HISTOGRAM DATA STORED ?
YES → 1520 — STORE HISTOGRAM DATA ON HARD DESK 26F
NO

1521 — ARE REFERENTIAL HISTOGRAMS DISPLAYED ?
YES → 1522 — READ HISTOGRAM DATA FROM HARD DESK 26F
PRODUCE VIDEO SIGNALS FOR HISTOGRAMS —1523
DISPLAY HISTOGRAMS ON TV MONITOR 28 —1524

1525 — ARE IMAGES REMOVED ?
YES → 1526 — REMOVE IMAGES FROM TV MONITOR 28

## Fig. 16

```
        ( HISTOGRAM PRODUCTION ROUTINE )
                        │
                ┌───────────────┐
                │    i ← 0       │
                │    j ← 0       │──── 1601
                │   MFQₖ ← 0     │
                └───────────────┘
                        │
  1602                  ▼ ◄─────────────────────────────┐
        ┌──────────────────────────────┐                │
        │  READ MFIᵢⱼ FROM RAM 26C      │                │
        └──────────────────────────────┘                │
                        │                                │
  1603 ──┌──────────────────────────────┐                │
        │  READ MFQₖ FROM RAM 26C        │                │
        └──────────────────────────────┘                │
                        │                                │
   1604 ──┌──────────────────────┐                       │
         │   MFQₖ ← MFQₖ+1        │                       │
         └──────────────────────┘                        │
                        │                                │
      1605 ──     ◇ i ≧ m ◇ ──NO──►  1606                │
                        │          ┌─────────┐           │
                       YES         │ i ← i+1 │           │
      1607 ──    ┌─────────┐       └─────────┘           │
               │  i ← 0   │────────────────────────────►│
                └─────────┘                              │
                        │                                │
     1608 ──    ◇ j ≧ n ◇ ──NO──►  1609                 │
                   ?    │          ┌─────────┐           │
                       YES         │ j ← j+1 │───────────┘
                        │          └─────────┘
   1610 ──┌──────────────────────┐
         │    j ← 0              │
         │   PFQₖ ← 0            │
         └──────────────────────┘
  1611                  │
                        ▼ ◄─────────────────────────────┐
        ┌──────────────────────────────┐                │
        │  READ PDFᵢⱼ FROM RAM 26C      │                │
        └──────────────────────────────┘                │
                        │                                │
  1612 ──┌──────────────────────────────┐                │
        │  READ PDQₖ FROM RAM 26C        │                │
        └──────────────────────────────┘                │
                        │                                │
   1613 ──┌──────────────────────┐                       │
         │   PDQₖ ← PDQₖ+1        │                       │
         └──────────────────────┘                        │
                        │                                │
      1614 ──     ◇ i ≧ m ◇ ──NO──►  1615                │
                        │          ┌─────────┐           │
                       YES         │ i ← i+1 │           │
      1616 ──    ┌─────────┐       └─────────┘           │
               │  i ← 0   │────────────────────────────►│
                └─────────┘                              │
                        │                                │
     1617 ──    ◇ j ≧ n ◇ ──NO──►  1618                 │
                        │          ┌─────────┐           │
                       YES         │ j ← j+1 │───────────┘
                        │          └─────────┘
                  ( RETURN )
```

EP 1 528 400 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003197700 A

- JP 2002313859 A

**Non-patent literature cited in the description**

- **JORN BEYER ; DIETMAR DRUNG ; THOMAS SCHURING.** SQUID Photoscanning: An Imaging Technique for UDN of Semiconductor Wafers and Devices based on Photomagnetic Detection. *IEEE Transactions on Applied Superconductivity,* March 2001, vol. 1, 1162-1167